# EUROPEAN PATENT APPLICATION

(11) **EP 4 626 200 A1**
(43) Date of publication of application: **01.10.2025**
(21) Application number: 25155709.6
(22) Date of filing: 04.02.2025
(51) Int. Cl.: H10K 59/80

(54) **DISPLAY DEVICE**

(30) Priority: 27.03.2024 KR 20240041771
(71) Applicant: Samsung Display Co., Ltd., Yongin-si, Gyeonggi-do 17113 (KR)
(72) Inventor: LEE, Hongyeon, Yongin-si (KR); KWON, Ohjeong, Yongin-si (KR); JEONG, Seungyeon, Yongin-si (KR); KANG, Hyeoji, Yongin-si (KR); KIM, Daewon, Yongin-si (KR)
(74) Representative: Marks & Clerk LLP

(57) **Abstract**

A display device includes a substrate including pixel areas and a non-light emitting area disposed between adjacent pixel areas, a driving circuit layer disposed on the substrate, a light emitting layer disposed on the driving circuit layer, a light-blocking layer disposed in the non-light emitting area on the light emitting layer and in a cross-sectional view, the light-blocking layer including a first surface facing the substrate, a second surface opposite to the first surface and forming a first inclination angle with the first surface, and a third surface opposite to the first surface, contacting the second surface, and forming a second inclination angle with the first surface, an insulating layer disposed on the light-blocking layer and including a groove in the non-light emitting area, and a reflecting pattern filling at least a portion of the groove.

## Description

### BACKGROUND

### 1. Technical Field

Embodiments relate to a display device. Embodiments relate to a display device including a color filter.

### 2. Description of the Related Art

A display device is a device that displays an image for providing visual information to a user. Among display devices, an organic light emitting diode display device has recently attracted attention.

Recently, a head mounted display ("HMD") including such display device has been developed. The head-mounted displays are glasses-type monitor devices of virtual reality ("VR") or augmented reality ("AR") that are worn in the form of glasses, helmets, etc. to form a focus near the user's eyes. A micro display may be applied to the head mounted display. An organic light emitting diode on silicon ("OLEDoS") display may be used as the micro display.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments provide a display device with improved light efficiency.

A display device according to an embodiment includes a substrate including a plurality of pixel areas and a non-light emitting area disposed between adjacent pixel areas of the plurality of pixel areas, a driving circuit layer disposed on the substrate; a light emitting layer disposed on the driving circuit layer; a light-blocking layer disposed in the non-light emitting area on the light emitting layer, and in a cross-sectional view, the light-blocking layer including a first surface facing the substrate; a second surface opposite to the first surface and forming a first inclination angle with the first surface; and a third surface opposite to the first surface, contacting the second surface, and forming a second inclination angle with the first surface; an insulating layer disposed on the light-blocking layer and including a groove in the non-light emitting area; and a reflecting pattern filling at least a portion of the groove.

In an embodiment, the first inclination angle and the second inclination angle may be substantially the same as each other.

In an embodiment, the groove may have a substantially triangular shape in cross-sectional view.

In an embodiment, the display device may further include a phase delay plate disposed on the insulating layer.

In an embodiment, the phase delay plate may include an about λ/4 phase delay plate.

In an embodiment, the display device may further include a wire grid polarizing plate disposed on the phase delay plate and including metal patterns spaced apart from each other at a selectable interval.

In an embodiment, a boundary surface at which the reflecting pattern and the insulating layer contact each other may form a third inclination angle with a lower surface of the phase delay plate.

In an embodiment, the third inclination angle may be greater than each of the first inclination angle and the second inclination angle.

In an embodiment, the light-blocking layer may include a metal.

In an embodiment, the reflecting pattern may include at least one of aluminium, gold, silver, copper, chromium, tungsten, iron, and nickel.

In an embodiment, the second surface may be a substantially curved surface.

In an embodiment, the display device may further include a color filter disposed in the plurality of pixel areas on the light emitting layer.

In an embodiment, the display device may further include an organic layer covering at least a portion of the color filter.

In an embodiment, a refractive index of the organic layer may be greater than a refractive index of the insulating layer.

In an embodiment, the groove may be a portion from which at least a portion of the insulating layer is removed from an upper surface of the insulating layer.

In an embodiment, the light-blocking layer may reflect at least a portion of light reflected by the reflecting pattern to an outside of the display device.

A display device according to an embodiment includes a substrate including a plurality of pixel areas and a non-light emitting area disposed between adjacent pixel areas; a driving circuit layer disposed on the substrate; a light emitting layer disposed on the driving circuit layer; a light-blocking layer disposed in the non-light emitting area on the light emitting layer, and in a cross-sectional view, the light-blocking layer including a first surface facing the substrate; a second surface opposite to the first surface and forming a first inclination angle with the first surface; and a third surface opposite to the first surface, contacting the second surface, and forming a second inclination angle with the first surface; an insulating layer disposed on the light-blocking layer; a phase delay plate disposed on the insulating layer; and a wire grid polarizing plate disposed on the phase delay plate, wherein the wire grid polarizing plate may include a reflecting pattern in the non-light emitting area.

In an embodiment, the reflecting pattern may include in the cross-sectional view a fourth surface reflecting light emitted from the light emitting layer to the light-blocking layer, a fifth surface contacting the fourth surface, and a sixth surface opposite to each of the fourth surface and the fifth surface.

In an embodiment, the fourth surface may form a third inclination angle with the sixth surface, and the fifth surface may form a fourth inclination angle with the sixth surface.

In an embodiment, the third inclination angle and the fourth inclination angle may be substantially the same as each other.

In an embodiment, the third inclination angle may be greater than each of the first inclination angle and the second inclination angle.

In an embodiment, the fourth surface may be a substantially curved surface.

In an embodiment, the light-blocking layer may include a metal.

In an embodiment, the display device may further include a color filter disposed in the plurality of pixel areas on the light emitting layer.

In an embodiment, the display device may further include an organic layer covering at least a portion of the color filter.

In an embodiment, a refractive index of the organic layer may be greater than a refractive index of the insulating layer.

In an embodiment, the light-blocking layer may reflect at least a portion of light reflected by the reflecting pattern to an outside of the display device.

A display device according to an embodiment includes a substrate including a plurality of pixel areas and a non-light emitting area disposed between adjacent pixel areas of the plurality of pixel areas; a driving circuit layer disposed on the substrate; a light emitting layer disposed on the driving circuit layer; a light-blocking layer disposed in the non-light emitting area on the light emitting layer, and in a cross-sectional view, the light-blocking layer including a first surface facing the substrate; a second surface opposite to the first surface and forming a first inclination angle with the first surface; and a third surface opposite to the first surface, contacting the second surface, and forming a second inclination angle with the first surface; an insulating layer disposed on the light-blocking layer and including a first groove in the non-light emitting area; a phase delay plate disposed on the insulating layer and including a second groove overlapping the first groove in a plan view; a first reflecting pattern filling at least a portion of the first groove and at least a portion of the second groove; and a wire grid polarizing plate disposed on the phase delay plate, wherein the wire grid polarizing plate may include a second reflecting pattern in the non-light emitting area.

In an embodiment, the first reflecting pattern may reflect at least a portion of light reflected by the second reflecting pattern to an outside of the display device.

In an embodiment, the light-blocking layer may reflect at least a portion of light reflected by the first reflecting pattern to an outside of the display device.

In an embodiment, the light-blocking layer may include a metal.

In an embodiment, the display device may further include a color filter disposed in the plurality of pixel areas on the light emitting layer.

In an embodiment, the display device may further include an organic layer covering at least a portion of the color filter.

In an embodiment, a refractive index of the organic layer may be greater than a refractive index of the insulating layer.

At least some of the above and other features of the invention are set out in the claims.

A display device according to embodiments may include a substrate, a driving circuit layer disposed on the substrate, a light emitting layer disposed on the driving circuit layer, an insulating layer disposed on the light emitting layer, a phase delay plate disposed on the insulating layer, and a wire grid polarizing plate disposed on the phase delay plate. As the display device may include a phase delay plate and a wire grid polarizing plate, some of the light emitted from the light emitting layer may be recycled. Thus, light efficiency of the display device may be improved.

The display device may further include a light-blocking layer and a reflecting pattern in a non-light emitting area. The light-blocking layer may include a first surface facing the substrate, a second surface opposite to the first surface, forming a first inclination angle with the first surface, and a third surface opposite to the first surface, contacting the second surface, and forming a second inclination angle with the first surface. The reflecting pattern may reflect at least a portion of light emitted from the light emitting layer to the light-blocking layer. The light-blocking layer may emit at least a portion of light reflected by the reflecting pattern to an outside of the display device.

Accordingly, the light efficiency of the display device may be further improved, and color mixing between adjacent pixel areas may be prevented.

### BRIEF DESCRIPTION OF THE DRAWINGS

Illustrative, non-limiting embodiments will be more clearly understood from the following detailed description in conjunction with the accompanying drawings in which:
FIG. 1 is a schematic plan view illustrating a display device according to an embodiment.
FIG. 2 is a schematic cross-sectional view of the display device of FIG. 1 taken along line I-I'.
FIGS. 3 and 4 are schematic cross-sectional views for illustrating a process in which light emitted from a light emitting layer included in the display device of FIG. 2 is recycled.
FIG. 5 is an enlarged schematic cross-sectional view illustrating an example of area A of FIG. 2.
FIG. 6 is an enlarged schematic cross-sectional view illustrating another example of area A of FIG. 2.
FIGS. 7 to 15 are schematic cross-sectional views illustrating a method of manufacturing the display device of FIG. 2.
FIG. 16 is a schematic cross-sectional view illustrating a display device according to an embodiment.
FIG. 17 is a schematic cross-sectional view for illustrating a process in which light emitted from a light emitting layer included in the display device of FIG. 16 is recycled.
FIG. 18 is a schematic cross-sectional view illustrating a display device according to an embodiment.
FIG. 19 is a schematic cross-sectional view for illustrating a process in which light emitted from a light emitting layer included in the display device of FIG. 18 is recycled.
Fig. 20 is an enlarged schematic cross-sectional view of area B of Fig. 18.
FIG. 21 is a schematic cross-sectional view illustrating a display device according to an embodiment.
FIG. 22 is a schematic cross-sectional view for illustrating a process in which light emitted from a light emitting layer included in the display device of FIG. 21 is recycled.
FIG. 23 is a schematic cross-sectional view illustrating a display device according to an embodiment.
FIG. 24 is a schematic cross-sectional view for illustrating a process in which light emitted from a light emitting layer included in the display device of FIG. 23 is recycled.
FIG. 25 is an enlarged schematic cross-sectional view illustrating an area C of FIG. 23.
FIG. 26 is a schematic cross-sectional view illustrating a display device according to an embodiment.
FIG. 27 is a schematic cross-sectional view for illustrating a process in which light emitted from a light emitting layer included in the display device of FIG. 26 is recycled.

### DETAILED DESCRIPTION OF THE EMBODIMENTS

Hereinafter, display devices in accordance with embodiments will be described in more detail with reference to the accompanying drawings. The same reference numerals are used for the same components in the drawings, and redundant descriptions of the same components may be omitted.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as `not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

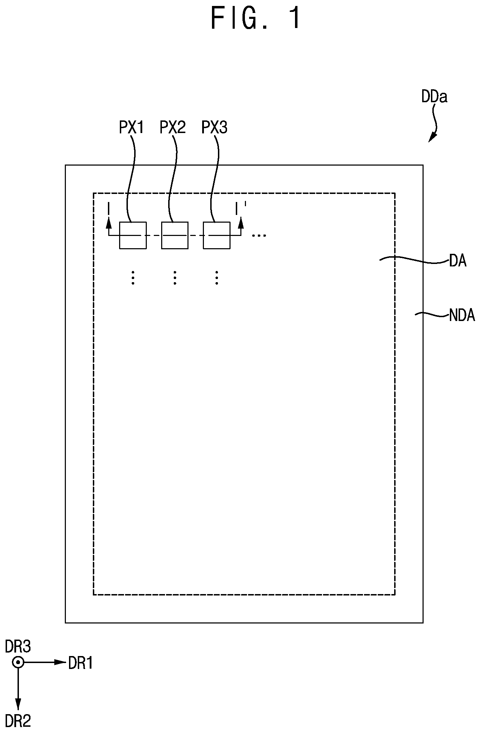

FIG. 1 is a schematic plan view illustrating a display device according to an embodiment.

Referring to FIG. 1, a display device DDa according to an embodiment may include a display area DA and a non-display area NDA.

The display area DA may be an area capable of generating light or displaying an image by adjusting transmittance of light provided from an external light source. The display area DA may include pixel areas. For example, the display area DA may include a first pixel area PX1, a second pixel area PX2, and a third pixel area PX3.

Each of the first pixel area PX1, the second pixel area PX2, and the third pixel area PX3 may mean an area in which light emitted from a light emitting element is emitted to an outside of the display device DDa. For example, the first pixel area PX1 may emit a first light, the second pixel area PX2 may emit a second light, and the third pixel area PX3 may emit a third light. The first light may be red light, the second light may be green light, and the third light may be blue light. However, this disclosure is not limited thereto. For example, the first pixel area PX1, the second pixel area PX2, and the third pixel area PX3 may be combined to emit yellow, cyan, and magenta light.

The pixel areas may be repeatedly arranged or disposed in a first direction DR1 and a second direction DR2 intersecting the first direction DR1 in the display area DA. For example, the second pixel area PX2 may be spaced apart from the first pixel area PX1 in the first direction DR1, and the third pixel area PX3 may be spaced apart from the second pixel area PX2 in the first direction DR1.

The non-display area NDA may be disposed around the display area DA. For example, the non-display area NDA may surround at least a portion of the display area DA. For example, the non-display area NDAmay entirely surround the display area DA. A driver may be disposed in the non-display area NDA. The driver may provide a signal or a voltage to the pixel areas. For example, the driver may include a data driver, a gate driver, and the like within the scope of the disclosure. The non-display area NDA may not display an image.

In an embodiment, the first direction DR1 and the second direction DR2 intersecting the first direction DR1 may be defined. For example, the second direction DR2 may be perpendicular to the first direction DR1. However, this disclosure is not limited thereto, and the second direction DR2 may form an acute angle or an obtuse angle with the first direction DR1. A third direction DR3 intersecting a plane formed by the first direction DR1 and second directions DR2 may be defined. For example, the third direction DR3 may be perpendicular to the plane formed by the first direction DR1 and second direction DR2. However, this disclosure is not limited thereto, and the third direction DR3 may form an acute angle or an obtuse angle with the plane formed by the first direction DR1 and second direction DR2.

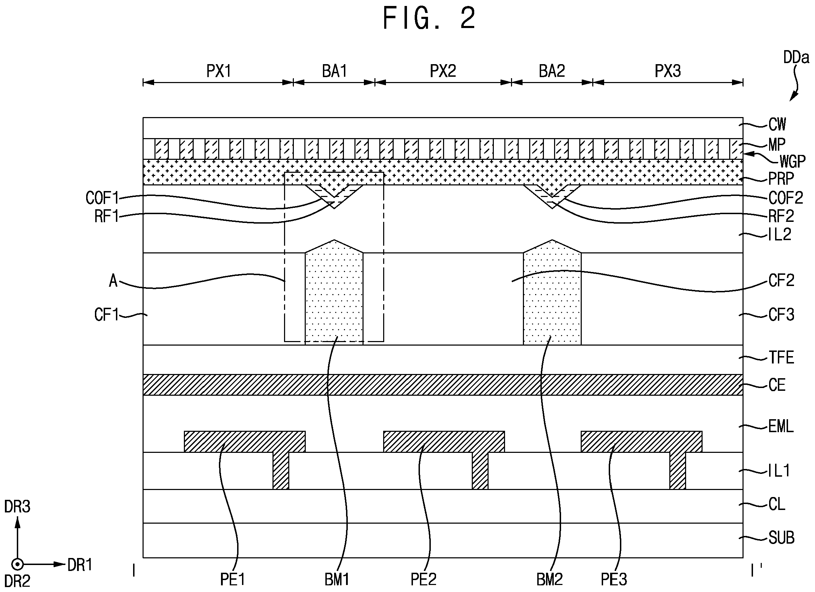

FIG. 2 is a schematic cross-sectional view of the display device of FIG. 1 taken along line I-I'.

Referring to FIG. 2, the display device DDa according to an embodiment may include a substrate SUB, a driving circuit layer CL, a first insulating layer IL1, a first pixel electrode PE1, a second pixel electrode PE2, a third pixel electrode PE3, a light emitting layer EML, a common electrode CE, an encapsulation layer TFE, a first color filter CF1, a second color filter CF2, a third color filter CF3, a first light-blocking layer BM1, a second light-blocking layer BM2, a second insulating layer IL2, a first reflecting pattern RF1, a second reflecting pattern RF2, a phase delay plate PRP, a wire grid polarizing plate WGP, and a cover window CW.

In an embodiment, the display device DDa may further include a non-light emitting area. For example, the non-light emitting area may be disposed between pixel areas adjacent to each other. For example, the first non-light emitting area BA1 may be disposed between the first pixel area PX1 and the second pixel area PX2. For example, the second non-light emitting area BA2 may be disposed between the second pixel area PX2 and the third pixel area PX3.

The substrate SUB may be a support member for supporting other components of the display device DDa. For example, the substrate SUB may be a silicon substrate. For example, the substrate SUB may be a p-type silicon substrate or an n-type silicon substrate. For example, p may mean a hole, and n may mean electron.

The driving circuit layer CL may be disposed on the substrate SUB. The driving circuit layer CL may include various driving elements, wirings, and the like for driving the light emitting element. For example, the driving circuit layer CL may include a transistor, a storage capacitor, a gate wiring, a data wiring, and the like within the scope of the disclosure.

The first insulating layer IL1 may be disposed on the driving circuit layer CL. The first insulating layer IL1 may prevent a contact between each of the first pixel electrode PE1, the second pixel electrode PE2, and the third pixel electrode PE3 and the driving circuit layer CL. For example, the first insulating layer IL1 may include an organic material and/or an inorganic material. For example, the first insulating layer IL1 may include an inorganic material such as silicon oxide ("SiOₓ"), silicon nitride ("SiNₓ"), silicon oxynitride ("SiOₓN_{y}"), or the like within the scope of the disclosure. These materials may be used alone or in combination with each other.

The first pixel electrode PE1, the second pixel electrode PE2, and the third pixel electrode PE3 may be disposed on the first insulating layer IL1. For example, the first pixel electrode PE1 may be disposed in the first pixel area PX1, the second pixel electrode PE2 may be disposed in the second pixel area PX2, and the third pixel electrode PE3 may be disposed in the third pixel area PX3.

The first pixel electrode PE1 may be connected to the driving circuit layer CL through a first contact hole defined through the first insulating layer IL1. The second pixel electrode PE2 may be connected to the driving circuit layer CL through a second contact hole defined through the first insulating layer IL1. The third pixel electrode PE3 may be connected to the driving circuit layer CL through a third contact hole defined through the first insulating layer IL1. Each of the first pixel electrode PE1, the second pixel electrode PE2, and the third pixel electrode PE3 may be an anode electrode.

For example, each of the first pixel electrode PE1, the second pixel electrode PE2, and the third pixel electrode PE3 may include a metal, an alloy metal nitride, a conductive metal oxide, a transparent conductive material, or the like within the scope of the disclosure. These materials may be used alone or in combination with each other.

Examples of the metal may include silver ("Ag"), molybdenum ("Mo"), aluminium ("Al"), tungsten ("W"), copper ("Cu"), nickel ("Ni"), chromium ("Cr"), titanium ("Ti"), tantalum ("Ta"), platinum ("Pt"), scandium ("Sc"), or the like within the scope of the disclosure. These materials may be used alone or in combination with each other.

Examples of the conductive metal oxide may include indium tin oxide, indium zinc oxide, or the like within the scope of the disclosure. These materials may be used alone or in combination with each other. Examples of the metal nitride may include aluminium nitride ("AlNₓ"), tungsten nitride ("WNₓ"), chromium nitride ("CrNₓ"), or the like within the scope of the disclosure. These materials may be used alone or in combination with each other.

The light emitting layer EML may be disposed on the first insulating layer IL1, the first pixel electrode PE1, the second pixel electrode PE2, and the third pixel electrode PE3. In an embodiment, the light emitting layer EML may be continuously disposed over the first pixel area PX1, the first non-light emitting area BA1, the second pixel area PX2, the second non-light emitting area BA2, and the third pixel area PX3. However, this disclosure is not limited thereto, and in an embodiment, the light emitting layer EML may be disposed on each of the first pixel electrode PE1, the second pixel electrode PE2, and the third pixel electrode PE3, and may not be disposed in the first non-light emitting area BA1 and the second non-light emitting area BA2.

For example, the light emitting layer EML may include a hole injection layer, a hole transport layer, an organic light emitting layer, an electron injection layer, an electron transport layer, and the like within the scope of the disclosure. In an embodiment, the organic light emitting layer may include a light emitting material that emits white light. For example, the white light may be a light in which blue light, green light and red light are mixed. By way of example, the white light may be a light in which blue light and yellow light are mixed. However, this disclosure is not limited thereto, and in an embodiment, the organic light emitting layer may include a light emitting material that emits light having a wavelength different from a wavelength of white light.

The common electrode CE may be disposed on the light emitting layer EML. In an embodiment, the common electrode CE may be continuously disposed over the first pixel area PX1, the first non-light emitting area BA1, the second pixel area PX2, the second non-light emitting area BA2, and the third pixel area PX3. For example, the common electrode CE may be a cathode electrode.

For example, the common electrode CE may include a metal, an alloy, a metal nitride, a conductive metal oxide, a transparent conductive material, or the like within the scope of the disclosure. These materials may be used alone or in combination with each other.

In the first pixel area PX1, the first pixel electrode PE1, the light emitting layer EML, and the common electrode CE may constitute a first light emitting element, in the second pixel area PX2, the second pixel electrode PE2, the light emitting layer EML, and the common electrode CE may constitute a second light emitting element, and in the third pixel area PX3, the third pixel electrode PE3, the light emitting layer EML, and the common electrode CE may constitute a third light emitting element.

The encapsulation layer TFE may be disposed on the common electrode CE. The encapsulation layer TFE may include at least one inorganic encapsulation layer and at least one organic encapsulation layer. For example, the inorganic encapsulation layer and the organic encapsulation layer may be alternately stacked on each other. For example, the inorganic encapsulation layer may include silicon oxide, silicon nitride, silicon oxynitride, or the like within the scope of the disclosure. These materials may be used alone or in combination with each other. For example, the organic encapsulation layer may include a cured polymer such as polyacrylate.

The first color filter CF1, the second color filter CF2, and the third color filter CF3 may be disposed on the encapsulation layer TFE. The first color filter CF1 may be disposed in the first pixel area PX1, the second color filter CF2 may be disposed in the second pixel area PX2, and the third color filter CF3 may be disposed in the third pixel area PX3.

Each of the first color filter CF1, the second color filter CF2, and the third color filter CF3 may selectively transmit light of a given wavelength and absorb remaining light. For example, the first color filter CF1 may transmit red light, the second color filter CF2 may transmit green light, and the third color filter CF3 may transmit blue light. Accordingly, the first pixel area PX1 may emit red light, the second pixel area PX2 may emit green light, and the third pixel area PX3 may emit blue light. However, this disclosure is not limited thereto.

The first light-blocking layer BM1 and the second light-blocking layer BM2 may be disposed on the encapsulation layer TFE. The first light-blocking layer BM1 may block light incident to the first light-blocking layer BM1, and the second light-blocking layer BM2 may block light incident to the second light-blocking layer BM2. The first light-blocking layer BM1 may be disposed in the first non-light emitting area BA1, and the second light-blocking layer BM2 may be disposed in the second non-light emitting area BA2. For example, the first light-blocking layer BM1 may be disposed between the first color filter CF1 and the second color filter CF2, and the second light-blocking layer BM2 may be disposed between the second color filter CF2 and the third color filter CF3. Accordingly, the first light-blocking layer BM1 may prevent color mixing between the first pixel area PX1 and the second pixel area PX2. The second light-blocking layer BM2 may prevent color mixing between the second pixel area PX2 and the third pixel area PX3.

In an embodiment, each of the first light-blocking layer BM1 and the second light-blocking layer BM2 may include a metal, an alloy metal nitride, a conductive metal oxide, a transparent conductive material, or the like within the scope of the disclosure. These materials may be used alone or in combination with each other. For example, each of the first light-blocking layer BM1 and the second light-blocking layer BM2 may include Ti/Al/Ti. However, this disclosure is not limited thereto, and any material capable of reflecting light may be used as the first light-blocking layer BM1 and the second light-blocking layer BM2.

The second insulating layer IL2 may be disposed on the first color filter CF1, the second color filter CF2, the third color filter CF3, the first light-blocking layer BM1, and the second light-blocking layer BM2. The second insulating layer IL2 may include a material capable of flattening a step of a configuration disposed under or below the second insulating layer IL2. For example, the second insulating layer IL2 may include a material capable of flattening a step of the first color filter CF1, the second color filter CF2, and the third color filter CF3.

In an embodiment, the second insulating layer IL2 may include an organic material. For example, the second insulating layer IL2 may include an acrylic resin, an epoxy resin, a phenolic resin, a polyamide resin, a polyimide resin, a polyester resin, a polyphenylenesulfide resin, a benzocyclobutene ("BCB"), or the like within the scope of the disclosure. These materials may be used alone or in combination with each other. However, this disclosure is not limited thereto, and in an embodiment, the second insulating layer IL2 may include an inorganic material. For example, the second insulating layer IL2 may include silicon oxide, silicon nitride, silicon oxynitride, or the like within the scope of the disclosure. These materials may be used alone or in combination with each other.

In an embodiment, the second insulating layer IL2 may define (or include) a first groove COF1 and a second groove COF2. The first groove COF1 may be disposed in at least a portion of the first non-light emitting area BA1. For example, the first groove COF1 may be a portion in which at least a portion of the second insulating layer IL2 is removed from an upper surface of the second insulating layer IL2 in the first non-light emitting area BA1. The second groove COF2 may be disposed in at least a portion of the second non-light emitting area BA2. For example, the second groove COF2 may be a portion in which at least a portion of the second insulating layer IL2 is removed from the upper surface of the second insulating layer IL2 in the second non-light emitting area BA2.

In an embodiment, the first groove COF1 may have a shape protruding toward the first light-blocking layer BM1. For example, the first groove COF1 may have a triangular shape in a cross-sectional view. However, this disclosure is not limited thereto, and the first groove COF1 may have a shape different from the triangular shape in the cross-sectional view.

In an embodiment, the second groove COF2 may have a shape protruding toward the second light-blocking layer BM2. For example, the second groove COF2 may have a triangular shape in the cross-sectional view. However, this disclosure is not limited thereto, and the second groove COF2 may have a shape different from the triangular shape in the cross-sectional view.

In an embodiment, the first reflecting pattern RF1 may fill at least a portion of the first groove COF1. For example, the first reflecting pattern RF1 may be disposed in at least a portion of the first non-light emitting area BA1. For example, the first reflecting pattern RF1 may have a V-shape in the cross-sectional view. However, this disclosure is not limited thereto, and the first reflecting pattern RF1 may entirely fill the first groove COF1. For example, the first reflecting pattern RF1 may have a substantially triangular shape in the cross-sectional view.

In an embodiment, the second reflecting pattern RF2 may fill at least a portion of the second groove COF2. For example, the second reflecting pattern RF2 may be disposed in at least a portion of the second non-light emitting area BA2. For example, the second reflecting pattern RF2 may have a V-shape in the cross-sectional view. However, this disclosure is not limited thereto, and the second reflecting pattern RF2 may entirely fill the second groove COF2. For example, the second reflecting pattern RF2 may have a triangular shape in the cross-sectional view

For example, each of the first reflecting pattern RF1 and the second reflecting pattern RF2 may include a metal, an alloy metal nitride, a conductive metal oxide, a transparent conductive material, or the like within the scope of the disclosure. These materials may be used alone or in combination with each other. For example, each of the first reflecting pattern RF1 and the second reflecting pattern RF2 may include aluminium, gold, silver, copper, chromium, tungsten, iron, nickel, or the like within the scope of the disclosure. These materials may be used alone or in combination with each other.

The phase delay plate PRP may be disposed on the second insulating layer IL2, the first reflecting pattern RF1, and the second reflecting pattern RF2. For example, the phase delay plate PRP may be in contact with the upper surface of the second insulating layer IL2. The phase delay plate PRP may be in contact with the first reflecting pattern RF1 and the second reflecting pattern RF2.

For example, the phase delay plate PRP may be a film type or a liquid crystal coating type. For example, the phase delay plate PRP may be separately manufactured and attached on the second insulating layer IL2, the first reflecting pattern RF1, and the second reflecting pattern RF2, or may be directly formed on the second insulating layer IL2, the first reflecting pattern RF1, and the second reflecting pattern RF2 through a semiconductor exposure machine.

For example, the phase delay plate PRP may include a λ/4 phase delay plate. For example, the phase delay plate PRP may delay a phase of light incident in the phase delay plate PRP by λ/4.

The wire grid polarizing plate WGP may be disposed on the phase delay plate PRP. For example, the wire grid polarizing plate WGP may be in contact with the phase delay plate PRP. For example, the wire grid polarizing plate WGP may include metal patterns MP spaced apart from each other at a selectable interval. The metal patterns MP may be spaced apart from each other in the first direction DR1.

For example, the wire grid polarizing plate WGP may be a film type or a liquid crystal coating type. For example, the wire grid polarizing plate WGP may be separately manufactured and attached on the phase delay plate PRP, or may be directly formed on the phase delay plate PRP through a semiconductor exposure machine.

For example, each of the metal patterns MP may extend in parallel in the second direction DR2. For example, light incident perpendicular to an extending direction of the wire grid polarizing plate WGP may pass through the wire grid polarizing plate WGP. On the other hand, light incident parallel to the extending direction of the wire grid polarizing plate WGP may be reflected by the wire grid polarizing plate WGP.

The wire grid polarizing plate WGP may include a metal having a relatively high reflectance. For example, the wire grid polarizing plate WGP may include a metal such as aluminium ("Al"), gold ("Au"), silver ("Ag"), copper ("Cu"), chromium ("Cr"), iron ("Fe"), nickel ("Ni"), or the like within the scope of the disclosure. These materials may be used alone or in combination with each other.

The cover window CW may be disposed on the wire grid polarizing plate WGP. The cover window CW may protect components disposed under or below the cover window CW For example, the cover window CW may include reinforced glass, reinforced plastic, or the like within the scope of the disclosure. By way of example, the cover window CW may be formed as a single layer or may have a structure in which functional layers are stacked on each other.

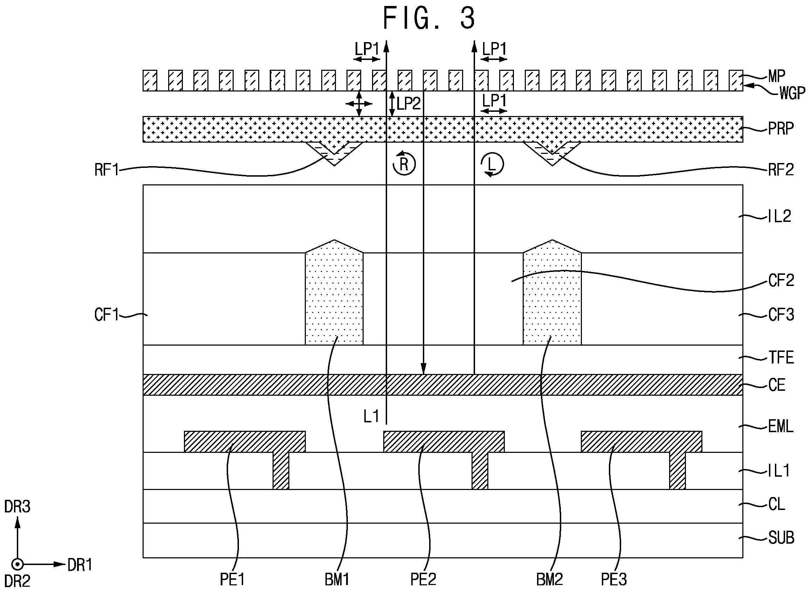

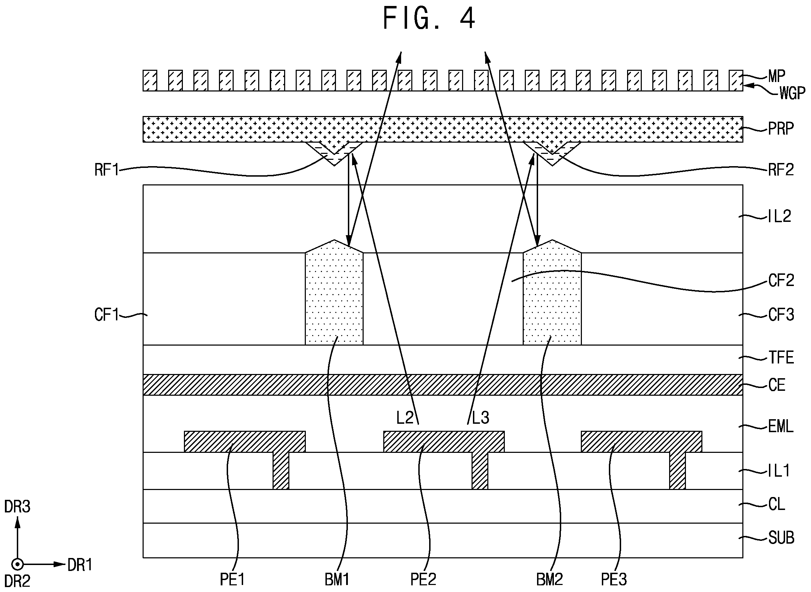

FIGS. 3 and 4 are schematic cross-sectional views for illustrating a process in which light emitted from a light emitting layer included in the display device of FIG. 2 is recycled.

By way of non-limiting example, FIG. 3 may illustrate a process in which light incident substantially perpendicular to the second color filter CF2 is recycled, and FIG. 4 may illustrate a process in which light obliquely incident on the second color filter CF2 is recycled. FIGS. 3 and 4 may illustrate a recycling process of light incident on the second color filter CF2, but this disclosure is not limited thereto, and a recycling process of light incident on each of the first color filter CF1 and the third color filter CF3 may be substantially the same as the recycling process described with reference to FIGS. 3 and 4.

Referring to FIG. 3, the light emitting layer EML may emit first light L1. The first light L1 may be incident substantially perpendicular to the second color filter CF2. Some of the light emitted from the light emitting layer EML may be recycled by the phase delay plate PRP and the wire grid polarizing plate WGP. For example, the first light L1 may pass through the phase delay plate PRP. A phase of the first light L1 passing through the phase delay plate PRP may be delayed by λ/4. The first light L1 passing through the phase delay plate PRP may be incident on the wire grid polarizing plate WGP. First linearly polarized light LP1 of the first light L1 incident on the wire grid polarizing plate WGP may pass, and second linearly polarized light LP2 of the first light L1 may be reflected. The first linearly polarized light LP1 may be light incident perpendicular to the extending direction of the wire grid polarizing plate WGP, and the second linearly polarized light LP2 may be light incident parallel to the extending direction of the wire grid polarizing plate WGP. The second linearly polarized light LP2 reflected from the wire grid polarizing plate WGP may be converted into first circularly polarized light R by being delayed in phase by λ/4 through the phase delay plate PRP. The first circularly polarized light R may be right circularly polarized light.

The first circularly polarized light R may be incident on the common electrode CE and may be reflected on the common electrode CE to be converted into second circularly polarized light L. The second circularly polarized light L may be left circularly polarized light. The second circularly polarized light L may be converted into the first linearly polarized light LP1 by being delayed in phase by λ/4 through the phase delay plate PRP. The first linearly polarized light LP1 may be incident on the wire grid polarizing plate WGP and may pass through the wire grid polarizing plate WGP.

As a result, by arranging the phase delay plate PRP and the wire grid polarizing plate WGP on the light emitting layer EML, some of the light emitted from the light emitting layer EML may be recycled without being blocked. For example, an absorption polarizing plate for blocking some of the light emitted from the light emitting layer EML may not be disposed on the light emitting layer EML. For example, the phase delay plate PRP and the wire grid polarizing plate WGP may replace the absorption polarizing plate. Accordingly, light efficiency of the display device DDa may be improved.

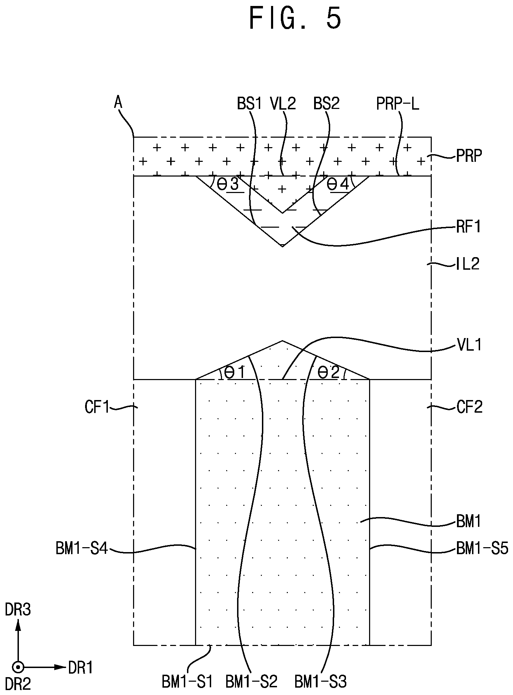

Referring to FIG. 4, the light emitting layer EML may emit second light L2 and third light L3. The second light L2 may be obliquely incident on the second color filter CF2. For example, the second light L2 may be incident on the first reflecting pattern RF1. At least a portion of the second light L2 incident on the first reflecting pattern RF1 may be reflected toward the first light-blocking layer BM1. For example, at least a portion of the second light L2 incident on a second boundary surface (for example, a second boundary surface BS2 of FIG. 5) of the first reflecting pattern RF1 may be reflected toward the first light-blocking layer BM1. For example, the first reflecting pattern RF1 may reflect at least a portion of the second light L2 emitted from the light emitting layer EML to the first light-blocking layer BM1. At least a portion of the second light L2 incident on the first light-blocking layer BM1 may be reflected toward the outside of the display device DDa. For example, at least a portion of the second light L2 incident on a third surface (for example, a third surface BM1-S3 of FIG. 5) of the first light-blocking layer BM1 may be reflected toward the outside of the display device DDa. For example, the first light-blocking layer BM1 may reflect at least a portion of the second light L2 reflected by the first reflecting pattern RF1 to the outside of the display device DDa.

The third light L3 may be obliquely incident on the second color filter CF2. For example, the third light L3 may be incident on the second reflecting pattern RF2. At least a portion of the third light L3 incident on the second reflecting pattern RF2 may be reflected toward the second light-blocking layer BM2. For example, at least a portion of the third light L3 incident on a first boundary surface of the second reflecting pattern RF2 may be reflected toward the second light-blocking layer BM2. For example, the second reflecting pattern RF2 may reflect at least a portion of the third light L3 emitted from the light emitting layer EML to the second light-blocking layer BM2. At least a portion of the third light L3 incident on the second light-blocking layer BM2 may be reflected toward the outside of the display device DDa. For example, at least a portion of the third light L3 incident on a second surface of the second light-blocking layer BM2 may be reflected toward the outside of the display device DDa. For example, the second light-blocking layer BM2 may reflect at least a portion of the third light L3 reflected by the second reflecting pattern RF2 to the outside of the display device DDa.

For example, as the display device DDa according to an embodiment may include the first light-blocking layer BM1, the second light-blocking layer BM2, the first reflecting pattern RF1, and the second reflecting pattern RF2, at least a portion of light obliquely incident on the first color filter CF1, the second color filter CF2, and the third color filter CF3 may be recycled, and thus, the light efficiency of the display device DDa may be further improved.

FIG. 5 is an enlarged schematic cross-sectional view illustrating an example of area A of FIG. 2.

Referring further to FIG. 5, the first light-blocking layer BM1 may include a first surface BM1-S1, a second surface BM1-S2, a third surface BM1-S3, a fourth surface BM1-S4, and a fifth surface BM1-S5. For example, the first light-blocking layer BM1 may be a portion surrounded by the first surface BM1-S1, the second surface BM1-S2, the third surface BM1-S3, the fourth surface BM1-S4, and the fifth surface BM1-S5 in the cross-sectional view.

The first surface BM1-S1 may be a surface facing the substrate SUB. For example, the first surface BM1-S1 may be a surface contacting the encapsulation layer TFE. For example, the first surface BM1-S1 may include a plane formed by the first direction DR1 and second direction DR2.

The second surface BM1-S2 may be opposite to the first surface BM1-S1. For example, the second surface BM1-S2 may be spaced apart from the first surface BM1-S1 in the cross-sectional view. For example, the second surface BM1-S2 may be spaced apart from the first surface BM1-S1 in the third direction DR3. In an embodiment, the second surface BM1-S2 may form a first inclination angle θ1 with the first surface BM1-S1. For example, the second surface BM1-S2 may form a first inclination angle θ1 with a first parallel surface VL1, which is a surface parallel to the first surface BM1-S1.

The third surface BM1-S3 may be opposite to the first surface BM1-S1. For example, the third surface BM1-S3 may be spaced apart from the first surface BM1-S1 in the cross-sectional view. For example, the third surface BM1-S3 may be spaced apart from the first surface BM1-S1 in the third direction DR3. The third surface BM1-S3 may be in contact with the second surface BM1-S2. In an embodiment, the third surface BM1-S3 may form a second inclination angle Θ2 with the first surface BM1-S1. For example, the third surface BM1-S3 may form a second inclination angle Θ2 with the first parallel surface VL1, which is a surface parallel to the first surface BM1-S1.

In an embodiment, the first inclination angle θ1 and the second inclination angle Θ2 may be substantially the same. For example, the first light-blocking layer BM1 may have a shape in which a rectangular and an isosceles triangle may be sequentially stacked on each other in the third direction DR3 in the cross-sectional view. However, this disclosure is not limited thereto, and in an embodiment, the first inclination angle θ1 and the second inclination angle Θ2 may be different from each other.

The fourth surface BM1-S4 may be in contact with the first surface BM1-S1 and the second surface BM1-S2. For example, the fourth surface BM1-S4 may be perpendicular to the first surface BM1-S1. For example, the fourth surface BM1-S4 may be a first side surface of the first light-blocking layer BM1.

The fifth surface BM1-S5 may be in contact with the first surface BM1-S1 and the third surface BM1-S3. For example, the fifth surface BM1-S5 may be perpendicular to the first surface BM1-S1. The fifth surface BM1-S5 may be spaced apart from the fourth surface BM1-S4 in the first direction DR1. For example, the fifth surface BM1-S5 may be a second side surface of the first light-blocking layer BM1.

The first reflecting pattern RF1 may include a first boundary surface BS1 and a second boundary surface BS2. For example, the first boundary surface BS1 may be a boundary surface at which the first reflecting pattern RF1 and the second insulating layer IL2 are in contact with each other. In an embodiment, the first boundary surface BS1 may form a third inclination angle Θ3 with a lower surface PRP-L of the phase delay plate PRP. The lower surface PRP-L of the phase delay plate PRP may be a surface at which the phase delay plate PRP and the second insulating layer IL2 are in contact with each other. For example, the first boundary surface BS1 may form a third inclination angle Θ3 with a second parallel surface VL2 which is a surface parallel to the lower surface PRP-L of the phase delay plate PRP.

The second boundary surface BS2 may be a boundary surface at which the first reflecting pattern RF1 and the second insulation layer IL2 are in contact with each other. The second boundary surface BS2 may be in contact with the first boundary surface BS1. For example, the second boundary surface BS2 may be in contact with the first boundary surface BS1 in the first direction DR1. In an embodiment, the second boundary surface BS2 may form a fourth inclination angle Θ4 with the lower surface PRP-L of the phase delay plate PRP. For example, the second boundary surface BS2 may form a fourth inclination angle Θ4 with the second parallel surface VL2 which is a surface parallel to the lower surface PRP-L of the phase delay plate PRP.

In an embodiment, the third inclination angle Θ3 and the fourth inclination angle Θ4 may be substantially the same. However, this disclosure is not limited thereto, and in an embodiment, the third inclination angle Θ3 and the fourth inclination angle Θ4 may be different from each other.

In an embodiment, the third inclination angle Θ3 may be greater than the first inclination angle θ1. The third inclination angle Θ3 may be greater than the second inclination angle Θ2. In an embodiment, the fourth inclination angle Θ4 may be greater than the first inclination angle θ1. The fourth inclination angle Θ4 may be greater than the second inclination angle Θ2.

Accordingly, a ratio of light emitted to the outside of the display device DDa among the light obliquely incident on the second color filter CF2 may increase by the first reflecting pattern RF1 and the first light-blocking layer BM1. Accordingly, the light efficiency of the display device DDa may be improved.

In an embodiment, each of the second surface BM1-S2 and the third surface BM1-S3 may be a plane. Each of the first boundary surface BS1 and the second boundary surface BS2 may be a plane.

Although the first light-blocking layer BM1 and the first reflecting pattern RF1 have been described with reference to FIG. 5, this disclosure is not limited thereto, and structure of the second light-blocking layer BM2 may be substantially the same as structure of the first light-blocking layer BM1, and the structure of the second reflecting pattern RF2 may be substantially the same as structure of the first reflecting pattern RF1.

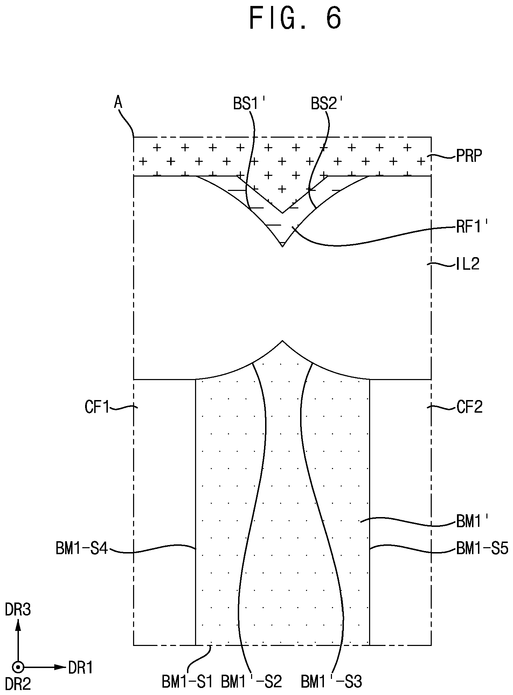

FIG. 6 is an enlarged schematic cross-sectional view illustrating another example of area A of FIG. 2.

A firstlight-blocking layer BM1' described with reference to FIG. 6 may be different in configurations of a second surface BM1'-S2 and a third surface BM1'-S3 compared to the first light-blocking layer BM1 described with reference to FIG. 5, and a first reflecting pattern RF1' described with reference to FIG. 6 may be different in configurations of a first boundary surface BS1' and a second boundary surface BS2' compared to the first reflecting pattern RF1 described with reference to FIG. 5. Therefore, overlapping descriptions may be omitted.

Referring to FIG. 6, a first light-blocking layer BM1' may include a first surface BM1-S1, a second surface BM1'-S2, a third surface BM1'-S3, a fourth surface BM1-S4, and a fifth surface BM1-S5. A first reflecting pattern RF1' may include a first boundary surface BS1' and a second boundary surface BS2'.

Each of the second surface BM1'-S2 and the third surface BM1'-S3 may be a curved surface. For example, each of the second surface BM1'-S2 and the third surface BM1' -S3 may have a parabolic shape that is convex downward in the cross-sectional view, but this disclosure is not limited thereto. Each of the first boundary surface BS1' and the second boundary surface BS2' may be a curved surface. For example, each of the first boundary surface BS1' and the second boundary surface BS2' may have a parabolic shape that is convex upward in the cross-sectional view, but this disclosure is not limited thereto.

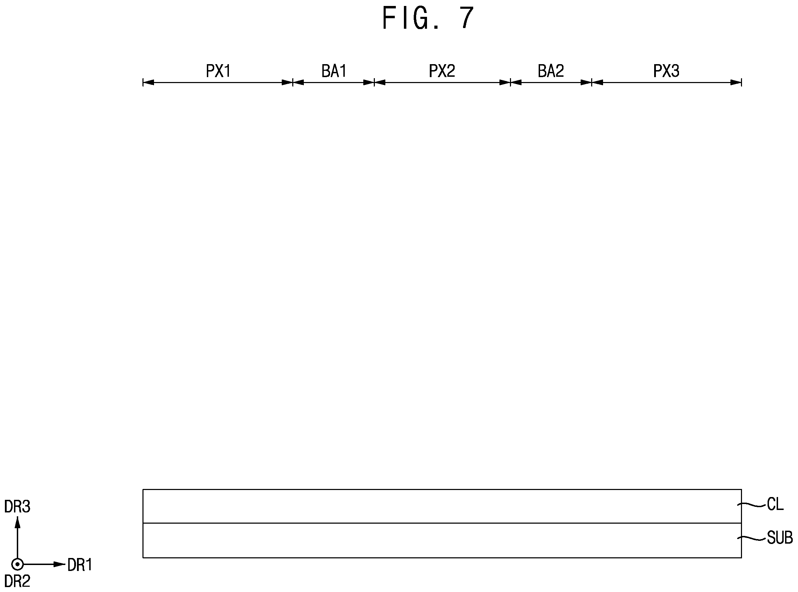

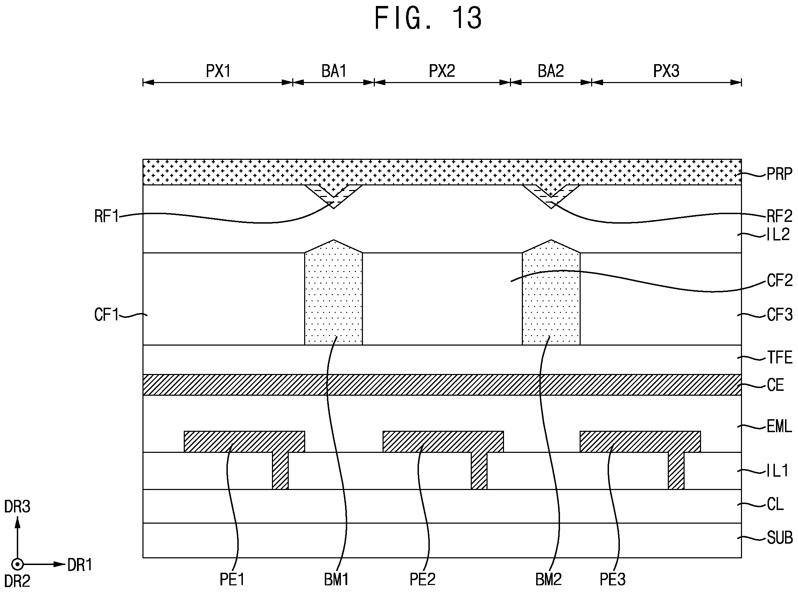

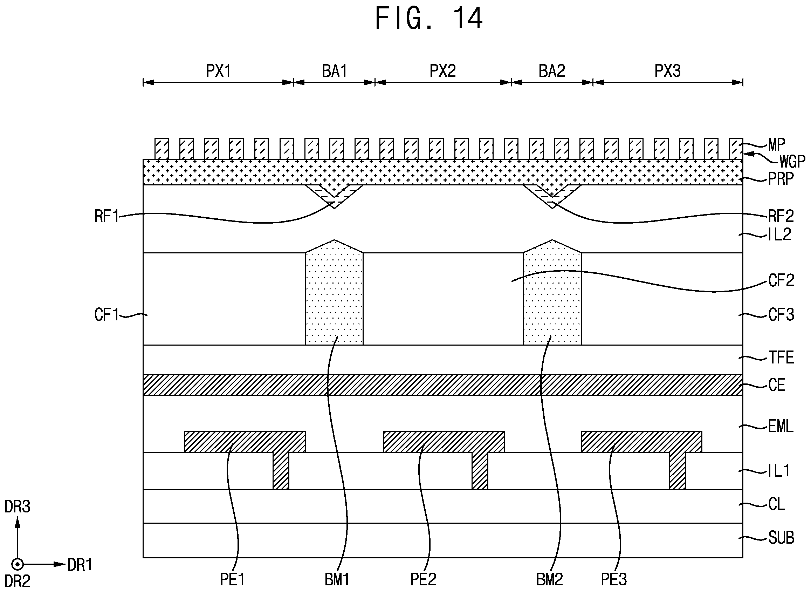

FIGS. 7 to 15 are schematic cross-sectional views illustrating a method of manufacturing the display device of FIG. 2.

Referring to FIG. 7, the driving circuit layer CL may be formed on the substrate SUB. For example, the substrate SUB may be a silicon substrate. The driving circuit layer CL may include various driving elements, wirings, and the like for driving the light emitting element. For example, the driving circuit layer CL may include a transistor, a storage capacitor, a gate wiring, a data wiring, and the like within the scope of the disclosure.

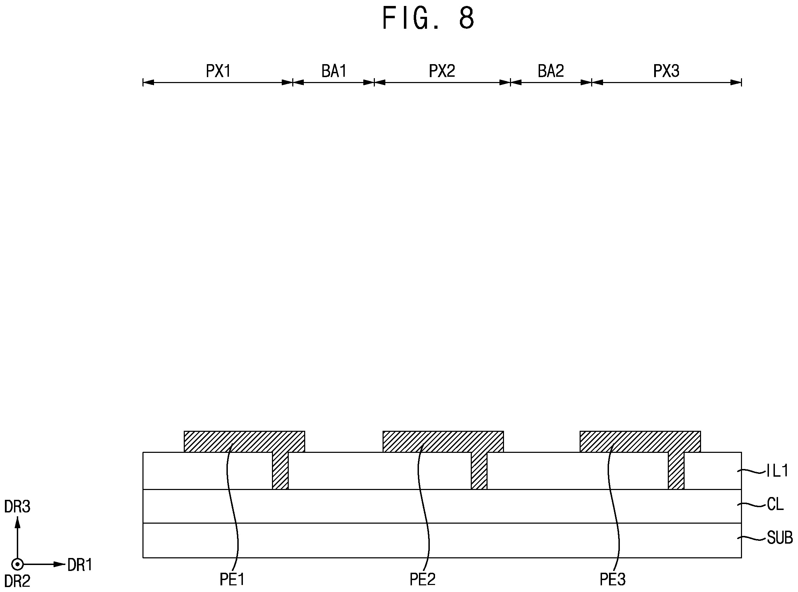

Referring to FIG. 8, the first insulating layer IL1 may be formed on the driving circuit layer CL. For example, the first insulating layer IL1 may include an organic material and/or an inorganic material. For example, the first insulating layer IL1 may include an inorganic material such as silicon oxide, silicon nitride, silicon oxynitride, or the like within the scope of the disclosure. These materials may be used alone or in combination with each other.

The first pixel electrode PE1, the second pixel electrode PE2, and the third pixel electrode PE3 may be formed on the first insulating layer IL1. The first pixel electrode PE1 may be formed in the first pixel area PX1. The second pixel electrode PE2 may be formed in the second pixel area PX2. The third pixel electrode PE3 may be formed in the third pixel area PX3. The first contact hole defined through the first insulating layer IL1 may be formed so that the first pixel electrode PE1 is connected to the driving circuit layer CL. The second contact hole defined through the first insulating layer IL1 may be formed so that the second pixel electrode PE2 is connected to the driving circuit layer CL. The third contact hole defined through the first insulating layer IL1 may be formed so that the third pixel electrode PE3 is connected to the driving circuit layer CL.

For example, each of the first pixel electrode PE1, the second pixel electrode PE2, and the third pixel electrode PE3 may include a metal, an alloy metal nitride, a conductive metal oxide, a transparent conductive material, or the like within the scope of the disclosure. These materials may be used alone or in combination with each other.

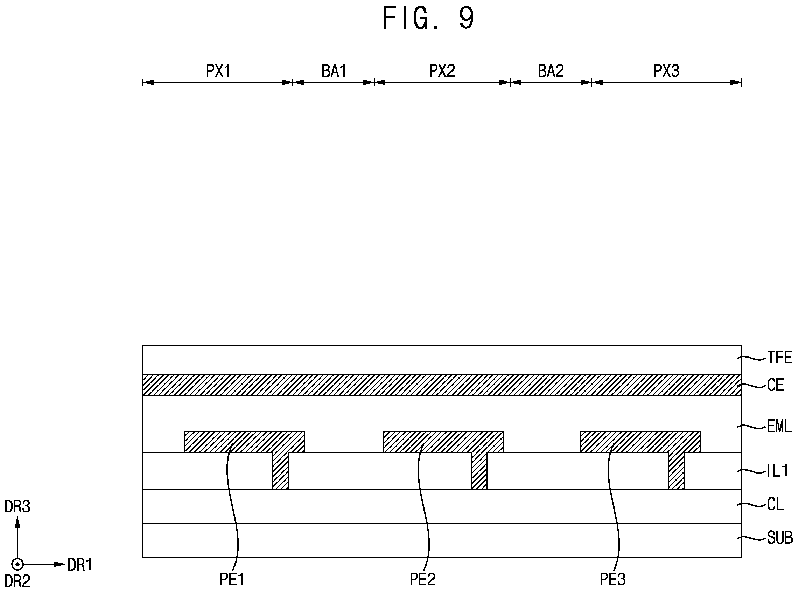

Referring to FIG. 9, the light emitting layer EML may be formed on the first insulating layer IL1, the first pixel electrode PE1, the second pixel electrode PE2, and the third pixel electrode PE3. In an embodiment, the light emitting layer EML may be continuously formed over the first pixel area PX1, the first non-light emitting area BA1, the second pixel area PX2, the second non-light emitting area BA2, and the third pixel area PX3.

For example, the light emitting layer EML may include a hole injection layer, a hole transport layer, an organic light emitting layer, an electron injection layer, an electron transport layer, and the like within the scope of the disclosure. In an embodiment, the organic light emitting layer may include a light emitting material that emits white light. For example, the white light may be a light in which blue light, green light and red light are mixed. By way of example, the white light may be a light in which blue light and yellow light are mixed. However, this disclosure is not limited thereto, and in an embodiment, the organic light emitting layer may include a light emitting material that emits light having a wavelength different from a wavelength of white light.

The common electrode CE may be formed on the light emitting layer EML. In an embodiment, the common electrode CE may be continuously formed over the first pixel area PX1, the first non-light emitting area BA1, the second pixel area PX2, the second non-light emitting area BA2, and the third pixel area PX3.

For example, the common electrode CE may include a metal, an alloy, a metal nitride, a conductive metal oxide, a transparent conductive material, or the like within the scope of the disclosure. These materials may be used alone or in combination with each other.

The encapsulation layer TFE may be formed on the common electrode CE. The encapsulation layer TFE may include at least one inorganic encapsulation layer and at least one organic encapsulation layer. For example, the inorganic encapsulation layer and the organic encapsulation layer may be alternately stacked on each other. For example, the inorganic encapsulation layer may include silicon oxide, silicon nitride, silicon oxynitride, or the like within the scope of the disclosure. These materials may be used alone or in combination with each other. For example, the organic encapsulation layer may include a cured polymer such as polyacrylate.

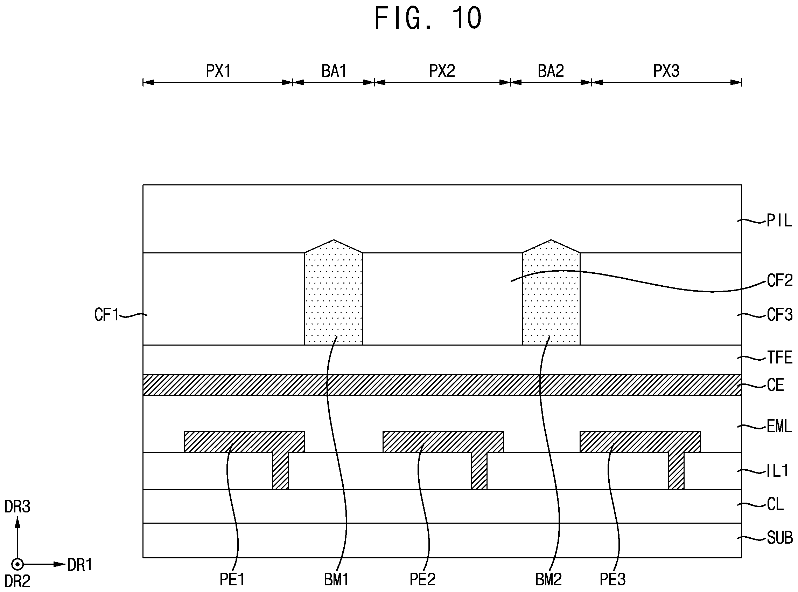

Referring to FIG. 10, the first color filter CF1, the second color filter CF2, and the third color filter CF3 may be formed on the encapsulation layer TFE. The first color filter CF1 may be formed in the first pixel area PX1, the second color filter CF2 may be formed in the second pixel area PX2, and the third color filter CF3 may be formed in the third pixel area PX3.

The first light-blocking layer BM1 and a second light-blocking layer BM2 may be formed on the encapsulation layer TFE. The first light-blocking layer BM1 may be formed in the first non-light emitting area BA1. The second light-blocking layer BM2 may be formed in the second non-light emitting area BA2.

As described above with reference to FIG. 5, the first light-blocking layer BM1 may include the first surface (e.g., the first surface BM1-S1 of FIG. 5), the second surface (e.g., the second surface BM1-S2 of FIG. 5), the third surface (e.g., the third surface BM1-S3 of FIG. 5), the fourth surface (e.g., the fourth surface BM1-S4 of FIG. 5), and the fifth surface (e.g., the fifth surface BM1-S5 of FIG. 5). In an embodiment, each of the second surface and the third surface may be formed through a processing method such as a laser or an electron beam. For example, a preliminary light-blocking layer may be formed in the first non-light emitting area BA1 on the encapsulation layer TFE, and the second surface and the third surface may be formed by removing a portion of an upper portion of the preliminary light-blocking layer through a laser or electron beam. However, this disclosure is not limited thereto, and the second surface and the third surface may be formed through various methods. The second light-blocking layer BM2 and the first light-blocking layer BM1 may be formed through substantially a same process.

In an embodiment, each of the first light-blocking layer BM1 and the second light-blocking layer BM2 may include a metal, an alloy metal nitride, a conductive metal oxide, a transparent conductive material, or the like within the scope of the disclosure. These materials may be used alone or in combination with each other.

For example, each of the first light-blocking layer BM1 and the second light-blocking layer BM2 may include Ti/Al/Ti. However, this disclosure is not limited thereto, and any material capable of reflecting light may be used as the first light-blocking layer BM1 and the second light-blocking layer BM2.

A preliminary insulating layer PIL may be formed on the first color filter CF1, the second color filter CF2, the third color filter CF3, the first light-blocking layer BM1, and the second light-blocking layer BM2. For example, the preliminary insulating layer PIL may include an organic material.

For example, the preliminary insulating layer PIL may include an acrylic resin, an epoxy resin, a phenolic resin, a polyamide resin, a polyimide resin, a polyester resin, a polyphenylenesulfide resin, a benzocyclobutene ("BCB"), or the like within the scope of the disclosure. These materials may be used alone or in combination with each other. However, this disclosure is not limited thereto, and in an embodiment, the preliminary insulating layer PIL may include an inorganic material. For example, the preliminary insulating layer PIL may include silicon oxide, silicon nitride, silicon oxynitride, or the like within the scope of the disclosure. These materials may be used alone or in combination with each other.

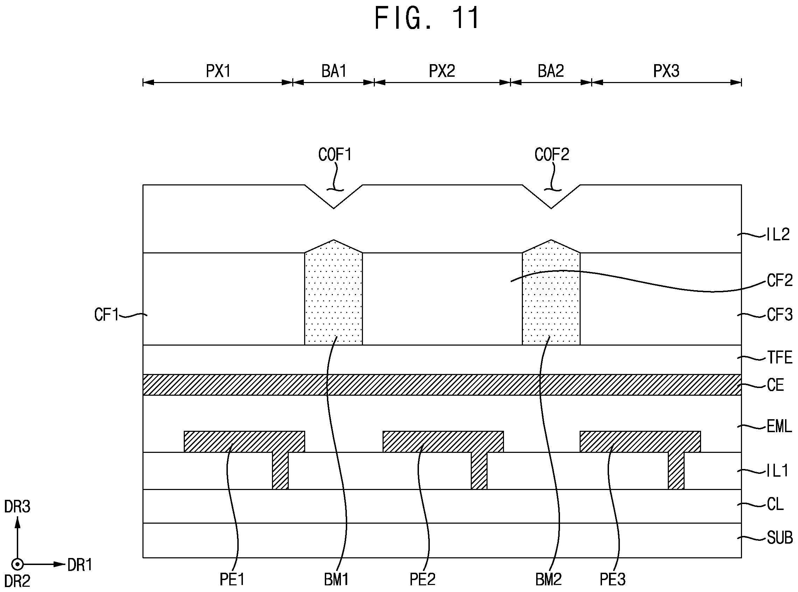

Referring further to FIG. 11, the first groove COF1 and the second groove COF2 may be formed in the preliminary insulating layer PIL. The first groove COF1 may be formed in at least a portion of the first non-light emitting area BA1. The first groove COF1 may be formed in the first non-light emitting area BA1 by removing at least a portion of the preliminary insulating layer PIL from an upper surface of the preliminary insulating layer PIL. The second groove COF2 may be formed in at least a portion of the second non-light emitting area BA2. The second groove COF2 may be formed in the second non-light emitting area BA2 by removing at least a portion of the preliminary insulating layer PIL from the upper surface of the preliminary insulating layer PIL. For example, as the first groove COF1 and the second groove COF2 are formed in the preliminary insulating layer PIL, the second insulating layer IL2 may be formed.

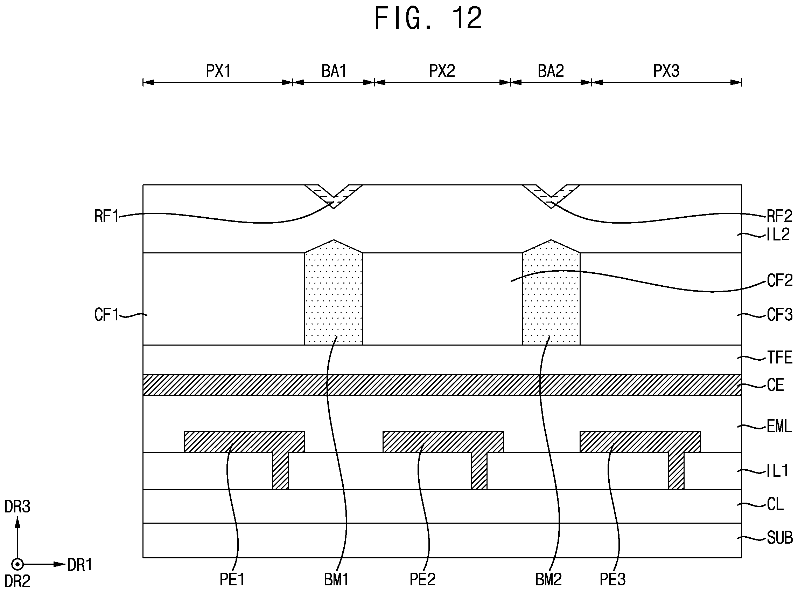

Referring to FIGS. 11 and 12, the first reflecting pattern RF1 may be formed to fill at least a portion of the first groove COF1. For example, the first reflecting pattern RF1 may be formed in at least a portion of the first non-light emitting area BA1. The second reflecting pattern RF2 may be formed to fill at least a portion of the second groove COF2. For example, the second reflecting pattern RF2 may be formed in at least a portion of the second non-light emitting area BA2.

For example, each of the first reflecting pattern RF1 and the second reflecting pattern RF2 may include a metal, an alloy metal nitride, a conductive metal oxide, a transparent conductive material, or the like within the scope of the disclosure. These materials may be used alone or in combination with each other. For example, each of the first reflecting pattern RF1 and the second reflecting pattern RF2 may include aluminium, gold, silver, copper, chromium, tungsten, iron, nickel, or the like within the scope of the disclosure. These materials may be used alone or in combination with each other.

The phase delay plate PRP may be formed on the second insulating layer IL2, the first reflecting pattern RF1, and the second reflecting pattern RF2. For example, the phase delay plate PRP may be a film type or a liquid crystal coating type. For example, the phase delay plate PRP may be separately manufactured and attached on the second insulating layer IL2, the first reflecting pattern RF1, and the second reflecting pattern RF2, or may be directly formed on the second insulating layer IL2, the first reflecting pattern RF1, and the second reflecting pattern RF2 through a semiconductor exposure machine. For example, the phase delay plate PRP may include a λ/4 phase delay plate.

The wire grid polarizing plate WGP may be formed on the phase delay plate PRP. For example, the wire grid polarizing plate WGP may include metal patterns MP spaced apart from each other at a selectable interval. The metal patterns MP may be spaced apart from each other in the first direction DR1.

For example, the wire grid polarizing plate WGP may be a film type or a liquid crystal coating type. For example, the wire grid polarizing plate WGP may be separately manufactured and attached on the phase delay plate PRP, or may be directly formed on the phase delay plate PRP through a semiconductor exposure machine.

The wire grid polarizing plate WGP may include a metal having a relatively high reflectance. For example, the wire grid polarizing plate WGP may include a metal such as aluminium ("Al"), gold ("Au"), silver ("Ag"), copper ("Cu"), chromium ("Cr"), iron ("Fe"), nickel ("Ni"), or the like within the scope of the disclosure. These materials may be used alone or in combination with each other.

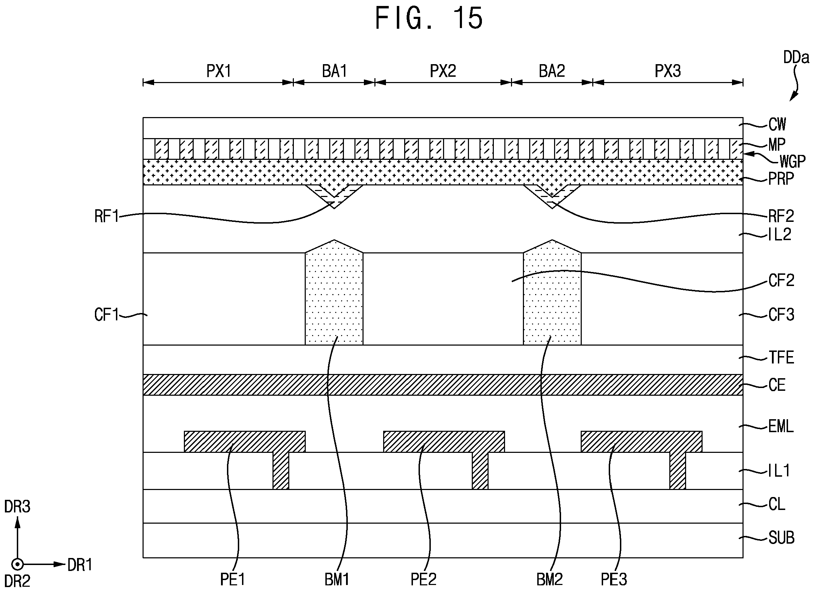

Referring to FIG. 15, the cover window CW may be formed on the wire grid polarizing plate WGP. For example, the cover window CW may include reinforced glass, reinforced plastic, or the like within the scope of the disclosure. By way of example, the cover window CW may be formed as a single layer or may have a structure in which functional layers may be stacked on each other.

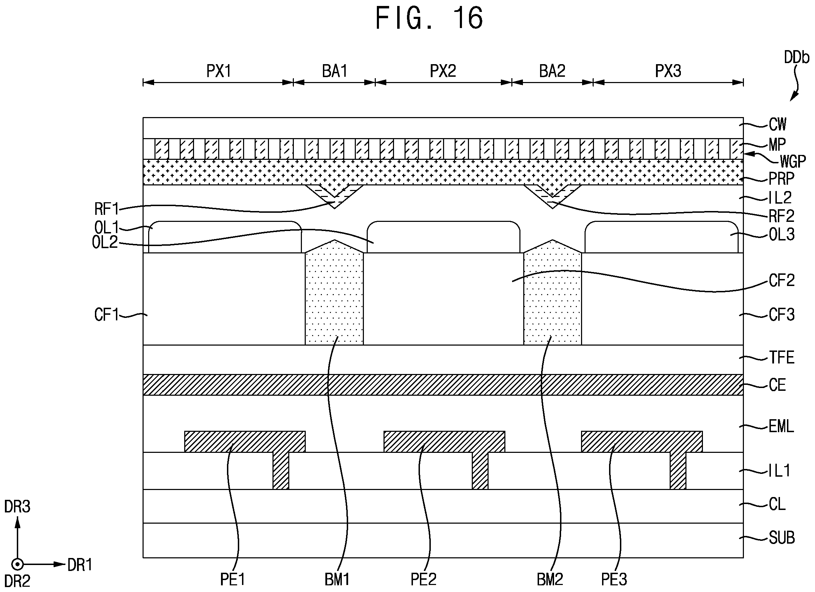

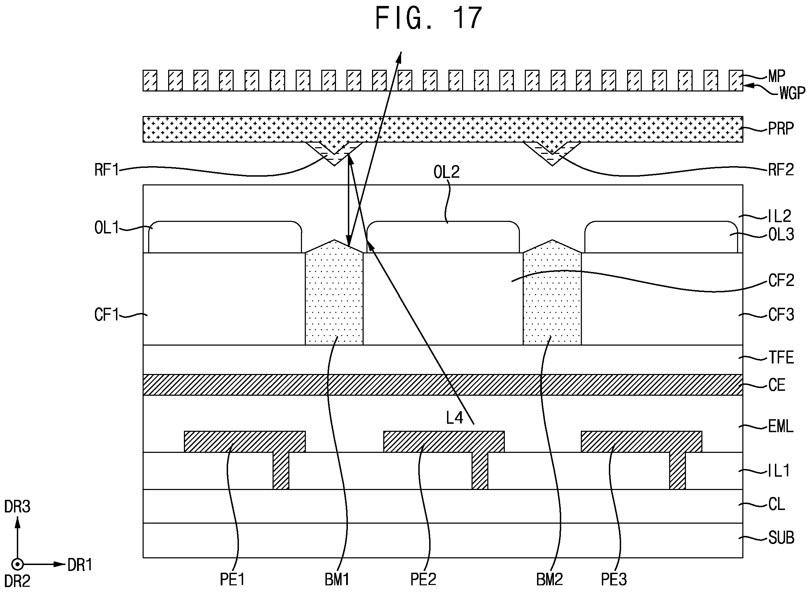

FIG. 16 is a schematic cross-sectional view illustrating a display device according to an embodiment. FIG. 17 is a schematic cross-sectional view for illustrating a process in which light emitted from a light emitting layer included in the display device of FIG. 16 is recycled.

A display device DDb according to an embodiment described with reference to FIG. 16 may be different in configurations of a first organic layer OL1, a second organic layer OL2, and a third organic layer OL3 compared to the display device DDa described with reference to FIG. 2. Therefore, overlapping description may be omitted.

Referring to FIGS. 16 and 17, a display device DDb according to another may include a first organic layer OL1, a second organic layer OL2, and a third organic layer OL3.

The first organic layer OL1 may be disposed on the first color filter CF1. For example, the first organic layer OL1 may cover at least a portion of the first color filter CF1. For example, the first organic layer OL1 may cover an upper surface of the first color filter CF1. For example, the first organic layer OL1 may be disposed in at least a portion of the first pixel area PX1.

The second organic layer OL2 may be disposed on the second color filter CF2. For example, the second organic layer OL2 may cover at least a portion of the second color filter CF2. For example, the second organic layer OL2 may cover an upper surface of the second color filter CF2. For example, the second organic layer OL2 may be disposed in at least a portion of the second pixel area PX2.

The third organic layer OL3 may be disposed on the third color filter CF3. For example, the third organic layer OL3 may cover at least a portion of the third color filter CF3. For example, the third organic layer OL3 may cover an upper surface of the third color filter CF3. For example, the third organic layer OL3 may be disposed in at least a portion of the third pixel area PX3.

For example, each of the first organic layer OL1, the second organic layer OL2, and the third organic layer OL3 may include an organic material. For example, each of the first organic layer OL1, the second organic layer OL2, and the third organic layer OL3 may include an organic material such as an epoxy resin, a siloxane resin, a polyimide resin, a photoresist, or the like within the scope of the disclosure. These materials may be used alone or in combination with each other.

As the display device DDb may include the first organic layer OL1, the second organic layer OL2, and the third organic layer OL3, the light efficiency of the display device DDb may be further improved. A mechanism for improving the light efficiency of the display device DDb will be described below, focusing on the second pixel area PX2.

The light emitting layer EML may emit fourth light L4. The fourth light L4 may be obliquely incident on the second color filter CF2. For example, the fourth light L4 may be emitted from the light emitting layer EML toward a portion other than the second boundary surface (for example, the second boundary surface BS2 of FIG. 5) of the first reflecting pattern RF1. As a refractive index of the second organic layer OL2 is greater than a refractive index of the second insulating layer IL2, the fourth light L4 may be refracted at a boundary surface between the second organic layer OL2 and the second insulating layer IL2. For example, the fourth light L4 may be refracted from the boundary surface between the second organic layer OL2 and the second insulating layer IL2 toward the second boundary surface of the first reflecting pattern RF1. Accordingly, the fourth light L4 may be emitted to an outside of the display device DDb through the first reflecting pattern RF1 and the first light-blocking layer BM1. For example, as the display device DDb may include the second organic layer OL2, light emitted from the light emitting layer EML toward a portion of the first reflecting pattern RF1 other than the second boundary surface may be refracted toward the first reflecting pattern RF1, and may be emitted to the outside of the display device DDb through the first reflecting pattern RF1 and the first light-blocking layer BM1. For example, as the display device DDb may include the second organic layer OL2, proportion of recycled light among the light obliquely incident on the second color filter CF2 may increase.

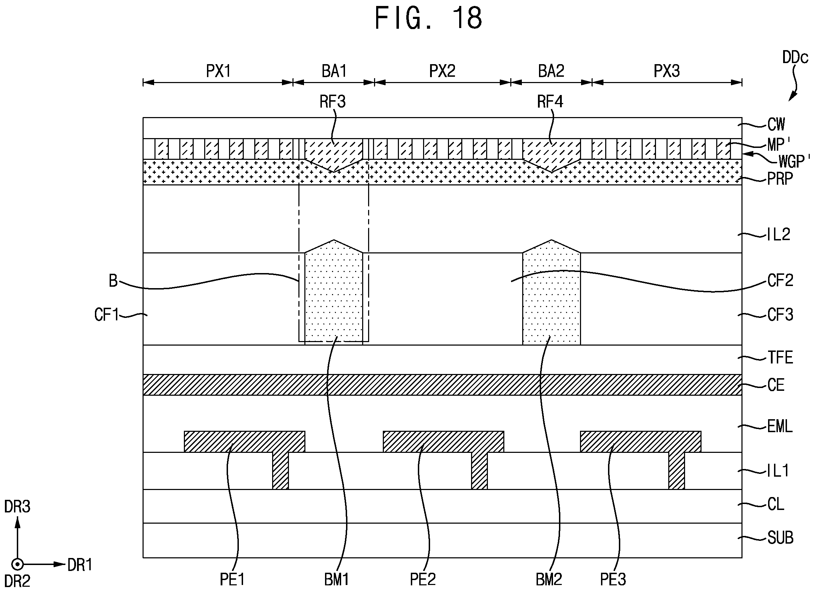

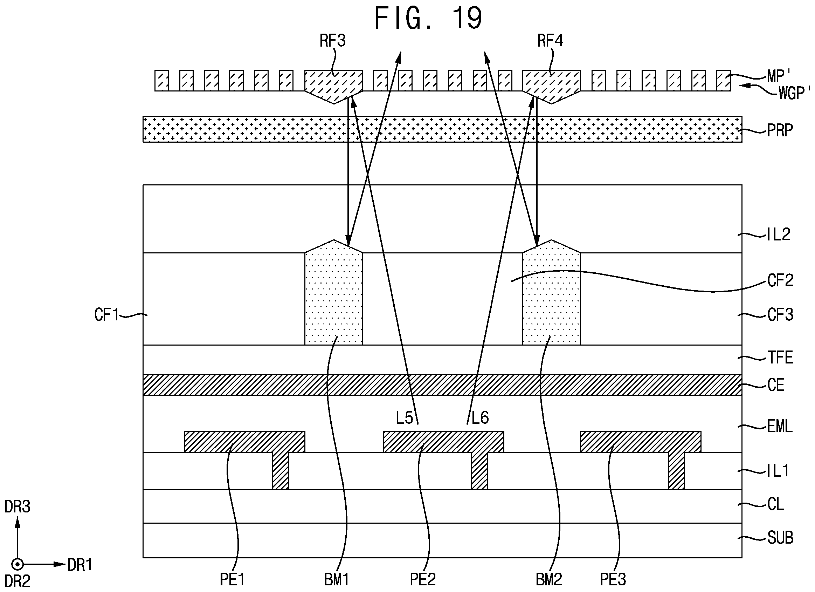

FIG. 18 is a schematic cross-sectional view illustrating a display device according to an embodiment. FIG. 19 is a schematic cross-sectional view for illustrating a process in which light emitted from a light emitting layer included in the display device of FIG. 18 is recycled.

A display device DDc according to an embodiment described with reference to FIG. 18 may not include the first reflecting pattern RF1 and the second reflecting pattern RF2 included in the display device DDa described with reference to FIG. 2. The display device DDc according to an embodiment may be different in configuration of a wire grid polarizing plate WGP' compared to the display device DDa described with reference to FIG. 2. Therefore, overlapping description may be omitted.

Referring to FIGS. 18 and 19, a display device DDc according to an embodiment may include a wire grid polarizing plate WGP'. The wire grid polarizing plate WGP' may be disposed on the phase delay plate PRP. For example, the wire grid polarizing plate WGP' may be in contact with the phase delay plate PRP. For example, the wire grid polarizing plate WGP' may include metal patterns MP' spaced apart from each other at a selectable interval. The metal patterns MP' may be spaced apart from each other in the first direction DR1. The metal patterns MP' may be disposed in the first pixel area PX1, the second pixel area PX2, and the third pixel area PX3. For example, the metal patterns MP' may not be disposed in the first non-light emitting area BA1 and the second non-light emitting area BA2.

In an embodiment, the wire grid polarizing plate WGP' may further include a third reflecting pattern RF3 and a fourth reflecting pattern RF4. The third reflecting pattern RF3 may be disposed in at least a portion of the first non-light emitting area BA1. For example, the third reflecting pattern RF3 may have a shape in which triangle and rectangle may be sequentially stacked in the third direction DR3 in the cross-sectional view, but this disclosure is not limited thereto.

The fourth reflecting pattern RF4 may be disposed in at least a portion of the second non-light emitting area BA2. For example, the fourth reflecting pattern RF4 may have a shape in which a triangle and a rectangle may be sequentially stacked in the third direction DR3 in the cross-sectional view, but this disclosure is not limited thereto.

Each of the third reflecting pattern RF3 and the fourth reflecting pattern RF4 may include a metal, an alloy metal nitride, a conductive metal oxide, a transparent conductive material, or the like within the scope of the disclosure. These materials may be used alone or in combination with each other. For example, each of the third reflecting pattern RF3 and the fourth reflecting pattern RF4 may include aluminium, gold, silver, copper, chromium, tungsten, iron, nickel, or the like within the scope of the disclosure. These materials may be used alone or in combination with each other.

FIG. 19 is a schematic cross-sectional view for illustrating a process in which light emitted from a light emitting layer included in the display device of FIG. 18 is recycled.

By way of non-limiting example, FIG. 19 may illustrate a process in which light obliquely incident on the second color filter CF2 included in the display device DDc according to another is recycled. The process in which light incident substantially perpendicular to the second color filter CF2 is recycled may be substantially the same as the process in which the first light L1 is recycled described with reference to FIG. 3, and thus overlapping descriptions may be omitted.

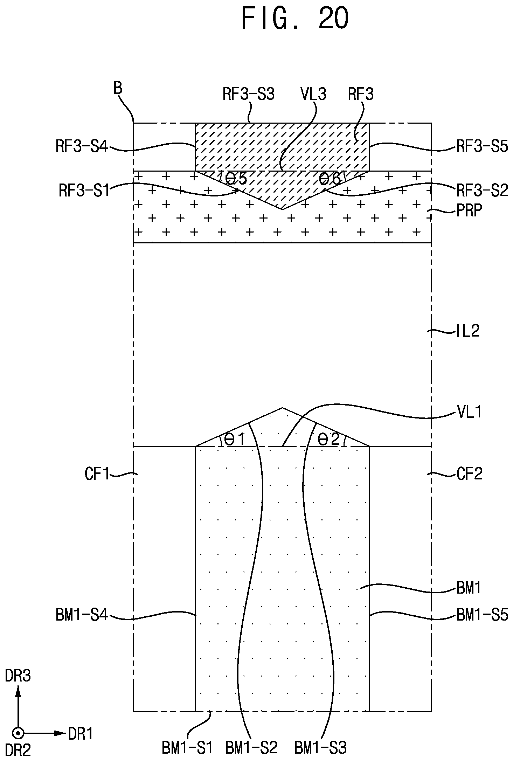

Referring to FIGS. 18 and 19, the light emitting layer EML may emit fifth light L5 and sixth light L6. The fifth light L5 may be obliquely incident on the second color filter CF2. For example, the fifth light L5 may be incident on the third reflecting pattern RF3. At least a portion of the fifth light L5 incident on the third reflecting pattern RF3 may be reflected toward the first light-blocking layer BM1. For example, at least a portion of the fifth light L5 incident on a second surface (for example, a second surface RF3-S2 of FIG. 20) of the third reflecting pattern RF3 may be reflected toward the first light-blocking layer BM1. For example, the third reflecting pattern RF3 may reflect at least a portion of the fifth light L5 emitted from the light emitting layer EML to the first light-blocking layer BM1. At least a portion of the fifth light L5 incident on the first light-blocking layer BM1 may be reflected toward an outside of the display device DDc. For example, at least a portion of the fifth light L5 incident on the third surface (for example, the third surface BM1-S3 of FIG. 20) of the first light-blocking layer BM1 may be reflected toward the outside of the display device DDc. For example, the first light-blocking layer BM1 may reflect at least a portion of the fifth light L5 reflected by the third reflecting pattern RF3 to the outside of the display device DDc.

The sixth light L6 may be obliquely incident on the second color filter CF2. For example, the sixth light L6 may be incident on the fourth reflecting pattern RF4. At least a portion of the sixth light L6 incident on the fourth reflecting pattern RF4 may be reflected toward the second light-blocking layer BM2. For example, at least a portion of the sixth light L6 incident on the first surface of the fourth reflecting pattern RF4 may be reflected toward the second light-blocking layer BM2. For example, the fourth reflecting pattern RF4 may reflect at least a portion of the sixth light L6 emitted from the light emitting layer EML to the second light-blocking layer BM2. At least a portion of the sixth light L6 incident on the second light-blocking layer BM2 may be reflected toward the outside of the display device DDc. For example, at least a portion of the sixth light L6 incident on the second surface of the second light-blocking layer BM2 may be reflected toward the outside of the display device DDc. For example, the second light-blocking layer BM2 may reflect at least a portion of the sixth light L6 reflected by the fourth reflecting pattern RF4 to the outside of the display device DDc.

For example, as the display device DDc according to an embodiment may include the first light-blocking layer BM1, the second light-blocking layer BM2, the third reflecting pattern RF3, and the fourth reflecting pattern RF4, at least a portion of light obliquely incident on the first color filter CF1, the second color filter CF2, and the third color filter CF3 may be recycled, and thus, the light efficiency of the display device DDc may be further improved.

Fig. 20 is an enlarged schematic cross-sectional view of area B of Fig. 18.

Referring further to FIG. 20, the third reflecting pattern RF3 may include a first surface RF3-S1, a second surface RF3-S2, a third surface RF3-S3, a fourth surface RF3-S4, and a fifth surface RF3-S5. For example, the third reflecting pattern RF3 may be a portion surrounded by the first surface RF3-S1, the second surface RF3-S2, the third surface RF3-S3, the fourth surface RF3-S4, and the fifth surface RF3-S5 in the cross-sectional view.

The first surface RF3-S1 may be opposite to the third surface RF3-S3. The third surface RF3-S3 may be a surface in contact with the cover window CW. For example, the first surface RF3-S1 may be spaced apart from the third surface RF3-S3 in the cross-sectional view. For example, the first surface RF3-S1 may be spaced apart from the third surface RF3-S3 in a direction opposite to the third direction DR3. In an embodiment, the first surface RF3-S1 may form a fifth inclination angle θ5 with the third surface RF3-S3. For example, the first surface RF3-S1 may form a fifth inclination angle θ5 with a third parallel surface VL3, which is a surface parallel to the third surface RF3-S3.

The second surface RF3-S2 may be opposite to the third surface RF3-S3. For example, the second surface RF3-S2 may be spaced apart from the third surface RF3-S3 in the cross-sectional view. For example, the second surface RF3-S2 may be spaced apart from the third surface RF3-S3 in a direction opposite to the third direction DR3. In an embodiment, the second surface RF3-S2 may form a sixth inclination angle Θ6 with the third surface RF3-S3. For example, the second surface RF3-S2 may form a sixth inclination angle Θ6 with the third parallel surface VL3, which is a surface parallel to the third surface RF3-S3.

In an embodiment, the fifth inclination angle θ5 and the sixth inclination angle Θ6 may be the same. For example, the third reflecting pattern RF3 may have a shape in which an isosceles triangle and a rectangle may be sequentially stacked in the third direction DR3 in the cross-sectional view. However, this disclosure is not limited thereto, and in an embodiment, the fifth inclination angle θ5 and the sixth inclination angle θ6 may be different from each other.

In an embodiment, the fifth inclination angle θ5 may be greater than the first inclination angle θ1. The fifth inclination angle θ5 may be greater than the second inclination angle Θ2. In an embodiment, the sixth inclination angle Θ6 may be greater than the first inclination angle θ1. The sixth inclination angle Θ6 may be greater than the second inclination angle Θ2. Accordingly, proportion of light emitted to the outside of the display device DDc by the third reflecting pattern RF3 and the first light-blocking layer BM1 among light obliquely incident on the second color filter CF2 may increase. Accordingly, the light efficiency of the display device DDc may be improved.

The fourth surface RF3-S4 may be in contact with the first surface RF3-S1 and the third surface RF3-S3. For example, the fourth surface RF3-S4 may be perpendicular to the third surface RF3-S3. For example, the fourth surface RF3-S4 may be a first side surface of the third reflecting pattern RF3.

The fifth surface RF3-S5 may be in contact with the second surface RF3-S2 and the third surface RF3-S3. For example, the fifth surface RF3-S5 may be perpendicular to the third surface RF3-S3. For example, the fifth surface RF3-S5 may be a second side surface of the third reflecting pattern RF3.

Although the third reflecting pattern RF3 has been described with reference to FIG. 20, this disclosure is not limited thereto, and the fourth reflecting pattern RF4 may have substantially the same structure as the third reflecting pattern RF3 of FIG. 20.

In an embodiment, the first surface RF3-S1 may be a flat surface. However, this disclosure is not limited thereto, and in an embodiment, the first surface RF3-S1 may be a curved surface. For example, the first surface RF3-S1 may have a parabolic shape that is convex upward in the cross-sectional view.

In an embodiment, the second surface RF3-S2 may be a flat surface. However, this disclosure is not limited thereto, and in an embodiment, the second surface RF3-S2 may be curved. For example, the second surface RF3-S2 may have a parabolic shape that is convex upward in the cross-sectional view.

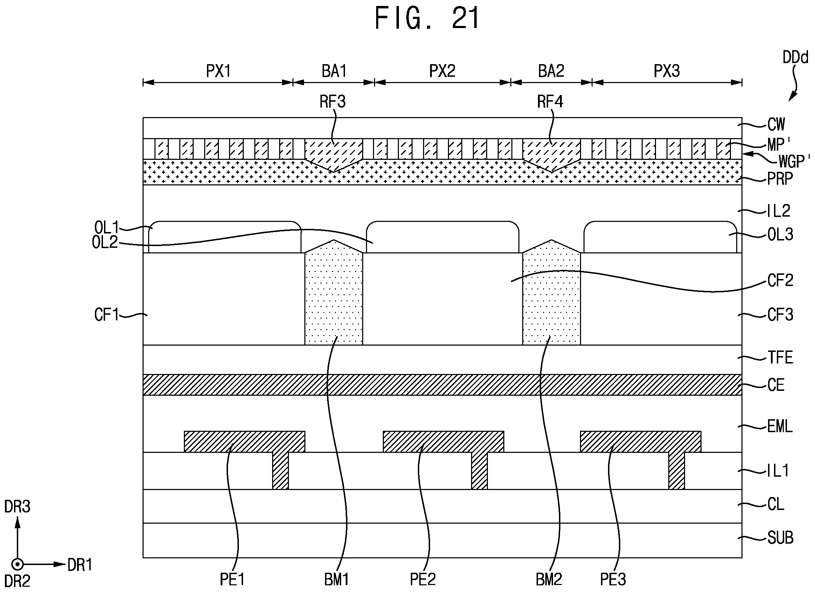

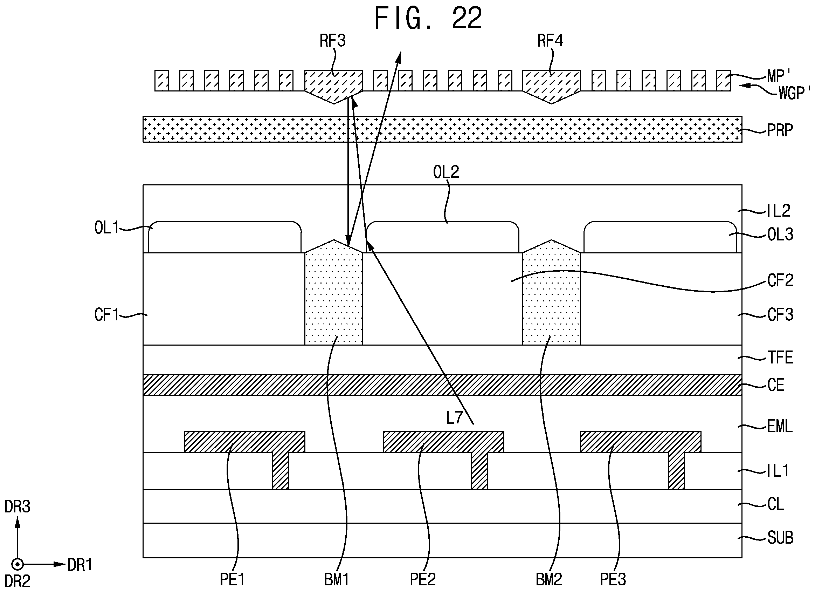

FIG. 21 is a schematic cross-sectional view illustrating a display device according to an embodiment. FIG. 22 is a schematic cross-sectional view for illustrating a process in which light emitted from a light emitting layer included in the display device of FIG. 21 is recycled.

A display device DDd according to an embodiment described with reference to FIG. 21 may be different from the display device DDc described with reference to FIG. 18 in the configurations of a first organic layer OL1, a second organic layer OL2, and a third organic layer OL3. Therefore, overlapping description may be omitted.

Referring to FIGS. 21 and 22, a first organic layer OL1 may be disposed on the first color filter CF1. For example, the first organic layer OL1 may cover at least a portion of the first color filter CF1. For example, the first organic layer OL1 may cover an upper surface of the first color filter CF1. For example, the first organic layer OL1 may be disposed in at least a portion of the first pixel area PX1.

The second organic layer OL2 may be disposed on the second color filter CF2. For example, the second organic layer OL2 may cover at least a portion of the second color filter CF2. For example, the second organic layer OL2 may cover an upper surface of the second color filter CF2. For example, the second organic layer OL2 may be disposed in at least a portion of the second pixel area PX2.

The third organic layer OL3 may be disposed on the third color filter CF3. For example, the third organic layer OL3 may cover at least a portion of the third color filter CF3. For example, the third organic layer OL3 may cover an upper surface of the third color filter CF3. For example, the third organic layer OL3 may be disposed in at least a portion of the third pixel area PX3.

In an embodiment, a refractive index of the first organic layer OL1 may be greater than a refractive index of the second insulating layer IL2. A refractive index of the second organic layer OL2 may be greater than the refractive index of the second insulating layer IL2. A refractive index of the third organic layer OL3 may be greater than the refractive index of the second insulating layer IL2.

For example, each of the first organic layer OL1, the second organic layer OL2, and the third organic layer OL3 may include an organic material. For example, each of the first organic layer OL1, the second organic layer OL2, and the third organic layer OL3 may include an organic material such as an epoxy resin, a siloxane resin, a polyimide resin, a photoresist, or the like within the scope of the disclosure. These materials may be used alone or in combination with each other.

As the display device DDd may include the first organic layer OL1, the second organic layer OL2, and the third organic layer OL3, light efficiency of the display device DDd may be further improved. A mechanism for improving the light efficiency of the display device DDd will be described below, focusing on the second pixel area PX2.

The light emitting layer EML may emit seventh light L7. The seventh light L7 may be obliquely incident on the second color filter CF2. For example, the seventh light L7 may be emitted from the light emitting layer EML toward a portion other than the second surface (for example, the second surface RF3-S2 of FIG. 20) of the third reflecting pattern RF3. As the refractive index of the second organic layer OL2 is greater than the refractive index of the second insulating layer IL2, the seventh light L7 may be refracted at a boundary surface between the second organic layer OL2 and the second insulating layer IL2. For example, the seventh light L7 may be refracted at the boundary surface between the second organic layer OL2 and the second insulating layer IL2 toward the second surface of the third reflecting pattern RF3. Accordingly, the seventh light L7 may be emitted to the outside of the display device DDd through the third reflecting pattern RF3 and the first light-blocking layer BM1. For example, as the display device DDd may include the second organic layer OL2, light emitted from the light emitting layer EML toward a portion other than the second surface of the third reflecting pattern RF3 may be refracted toward the third reflecting pattern RF3, and may be emitted to the outside of the display device DDd through the third reflecting pattern RF3 and the first light-blocking layer BM1. For example, as the display device DDd may include the second organic layer OL2, proportion of recycled light among the light obliquely incident on the second color filter CF2 may increase.

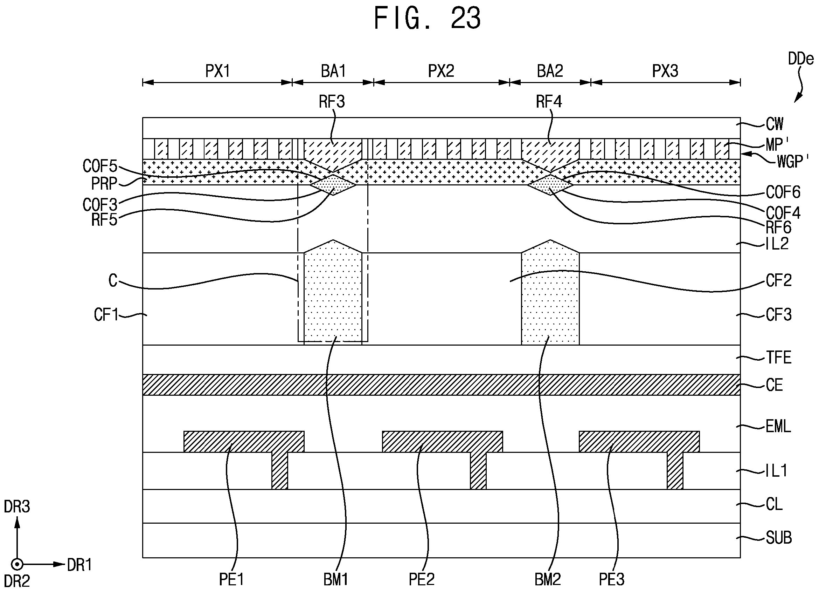

FIG. 23 is a schematic cross-sectional view illustrating a display device according to an embodiment.

A display device DDe according to an embodiment described with reference to FIG. 23 may be different from the display device DDc described with reference to FIG. 18 in the configuration of a fifth reflecting pattern RF5 and the sixth reflecting pattern RF6. Accordingly, overlapping descriptions may be omitted.

Referring to FIG. 23, a display device DDe according to an embodiment may include a fifth reflecting pattern RF5 and a sixth reflecting pattern RF6.

The second insulating layer IL2 may define a third groove COF3 and a fourth groove COF4. The third groove COF3 may be disposed in at least a portion of the first non-light emitting area BA1. For example, the third groove COF3 may be a portion in which at least a portion of the second insulating layer IL2 is removed from an upper surface of the second insulating layer IL2 in the first non-light emitting area BA1. The fourth groove COF4 may be disposed in at least a portion of the second non-light emitting area BA2. For example, the fourth groove COF4 may be a portion in which at least a portion of the second insulating layer IL2 is removed from the upper surface of the second insulating layer IL2 in the second non-light emitting area BA2.

In an embodiment, the third groove COF3 may have a shape protruding toward the first light-blocking layer BM1. For example, the third groove COF3 may have a triangular shape in the cross-sectional view. However, this disclosure is not limited thereto, and the third groove COF3 may have a shape different from the triangular shape in the cross-sectional view.

In an embodiment, the fourth groove COF4 may have a shape protruding toward the second light-blocking layer BM2. For example, the fourth groove COF4 may have a triangular shape in the cross-sectional view. However, this disclosure is not limited thereto, and the fourth groove COF4 may have a shape different from the triangular shape in the cross-sectional view.

The phase delay plate PRP may define a fifth groove COF5 and a sixth groove COF6. The fifth groove COF5 may be disposed in at least a portion of the first non-light emitting area BA1. For example, the fifth groove COF5 may overlap the third groove COF3 in a plan view. For example, the fifth groove COF5 may be a portion in which at least a portion of the phase delay plate PRP is removed from a lower surface of the phase delay plate PRP in the first non-light emitting area BA1.

The sixth groove COF6 may be disposed in at least a portion of the second non-light emitting area BA2. For example, the sixth groove COF6 may overlap the fourth groove COF4 in the plan view. For example, the sixth groove COF6 may be a portion in which at least a portion of the phase delay plate PRP is removed from the lower surface of the phase delay plate PRP in the second non-light emitting area BA2.

In an embodiment, the fifth reflecting pattern RF5 may fill at least a portion of the third groove COF3. For example, the fifth reflecting pattern RF5 may entirely fill the third groove COF3. In an embodiment, the fifth reflecting pattern RF5 may fill at least a portion of the fifth groove COF5. For example, the fifth reflecting pattern RF5 may entirely fill the fifth groove COF5. For example, the fifth reflecting pattern RF5 may be disposed in the first non-light emitting area BA1. For example, the fifth reflecting pattern RF5 may overlap the first light-blocking layer BM1 and the third reflecting pattern RF3 in the plan view.

In an embodiment, the sixth reflecting pattern RF6 may fill at least a portion of the fourth groove COF4. For example, the sixth reflecting pattern RF6 may entirely fill the fourth groove COF4. In an embodiment, the sixth reflecting pattern RF6 may fill at least a portion of the sixth groove COF6. For example, the sixth reflecting pattern RF6 may entirely fill the sixth groove COF6. For example, the sixth reflecting pattern RF6 may be disposed in the second non-light emitting area BA2. For example, the sixth reflecting pattern RF6 may overlap the second light-blocking layer BM2 and the fourth reflecting pattern RF4 in the plan view.

Each of the fifth reflecting pattern RF5 and the sixth reflecting pattern RF6 may include a metal, an alloy metal nitride, a conductive metal oxide, a transparent conductive material, or the like within the scope of the disclosure. These materials may be used alone or in combination with each other. For example, each of the fifth reflecting pattern RF5 and the sixth reflecting pattern RF6 may include aluminium, gold, silver, copper, chromium, tungsten, iron, nickel, or the like within the scope of the disclosure. These materials may be used alone or in combination with each other.

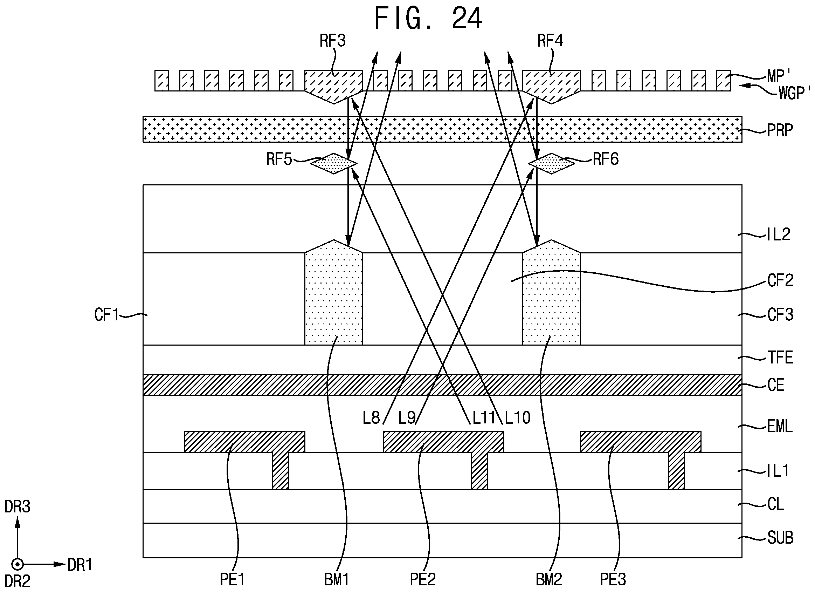

FIG. 24 is a schematic cross-sectional view for illustrating a process in which light emitted from a light emitting layer included in the display device of FIG. 23 is recycled.

By way of non-limiting example, FIG. 24 may illustrate a process in which light obliquely incident on the second color filter CF2 included in the display device DDe according to an embodiment is recycled. The recycling process of light incident substantially perpendicular to the second color filter CF2 may be substantially the same as the process of recycling the first light L1 described with reference to FIG. 3, and thus overlapping description may be omitted.

Referring to FIGS. 23 and 24, the light emitting layer EML may emit eighth light L8, ninth light L9, tenth light L10, and eleventh light L11.

The eighth light L8 may be obliquely incident on the second color filter CF2. For example, the eighth light L8 may be incident on the fourth reflecting pattern RF4. At least a portion of the eighth light L8 incident on the fourth reflecting pattern RF4 may be reflected toward the sixth reflecting pattern RF6. For example, at least a portion of the eighth light L8 incident on a first surface of the fourth reflecting pattern RF4 may be reflected toward the sixth reflecting pattern RF6. For example, the fourth reflecting pattern RF4 may reflect at least a portion of the eighth light L8 emitted from the light emitting layer EML to the sixth reflecting pattern RF6. At least a portion of the eighth light L8 incident on the sixth reflecting pattern RF6 may be reflected toward an outside of the display device DDe. For example, at least a portion of the eighth light L8 incident on a third surface of the sixth reflecting pattern RF6 may be reflected toward the outside of the display device DDe. For example, the sixth reflecting pattern RF6 may reflect at least a portion of the eighth light L8 reflected by the fourth reflecting pattern RF4 to the outside of the display device DDe.

The ninth light L9 may be obliquely incident on the second color filter CF2. For example, the ninth light L9 may be incident on the sixth reflecting pattern RF6. At least a portion of the ninth light L9 incident on the sixth reflecting pattern RF6 may be reflected toward the second light-blocking layer BM2. For example, at least a portion of the ninth light L9 incident on a first surface of the sixth reflecting pattern RF6 may be reflected toward the second light-blocking layer BM2. For example, the sixth reflecting pattern RF6 may reflect at least a portion of the ninth light L9 emitted from the light emitting layer EML to the second light-blocking layer BM2. At least a portion of the ninth light L9 incident on the second light-blocking layer BM2 may be reflected toward the outside of the display device DDe. For example, at least a portion of the ninth light L9 incident on a second surface of the second light-blocking layer BM2 may be reflected toward the outside of the display device DDe. For example, the second light-blocking layer BM2 may reflect at least a portion of the ninth light L9 reflected by the sixth reflecting pattern RF6 to the outside of the display device DDe.

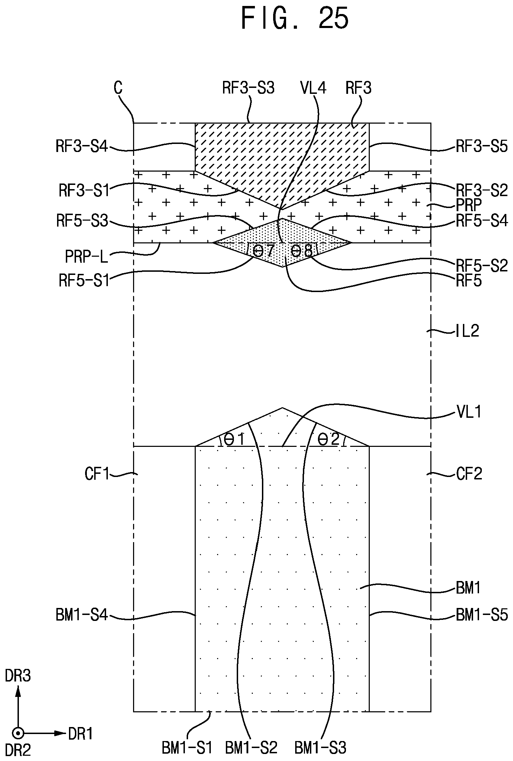

The tenth light L10 may be obliquely incident on the second color filter CF2. For example, the tenth light L10 may be incident on the third reflecting pattern RF3. At least a portion of the tenth light L10 incident on the third reflecting pattern RF3 may be reflected toward the fifth reflecting pattern RF5. For example, at least a portion of the tenth light L10 incident on the second surface (for example, the second surface RF3-S2 of FIG. 25) of the third reflecting pattern RF3 may be reflected toward the fifth reflecting pattern RF5. For example, the third reflecting pattern RF3 may reflect at least a portion of the tenth light L10 emitted from the light emitting layer EML to the fifth reflecting pattern RF5. At least a portion of the tenth light L10 incident on the fifth reflecting pattern RF5 may be reflected toward the outside of the display device DDe. For example, at least a portion of the tenth light L10 incident on a fourth surface (for example, a fourth surface RF5-S4 of FIG. 25) of the fifth reflecting pattern RF5 may be reflected toward the outside of the display device DDe. For example, the fifth reflecting pattern RF5 may reflect at least a portion of the tenth light L10 reflected by the third reflecting pattern RF3 to the outside of the display device DDe.

The eleventh light L11 may be obliquely incident on the second color filter CF2. For example, the eleventh light L11 may be incident on the fifth reflecting pattern RF5. At least a portion of the eleventh light L11 incident on the fifth reflecting pattern RF5 may be reflected toward the first light-blocking layer BM1. For example, at least a portion of the eleventh light L11 incident on a second surface (for example, a second surface RF5-S2 of FIG. 25) of the fifth reflecting pattern RF5 may be reflected toward the first light-blocking layer BM1. For example, the fifth reflecting pattern RF5 may reflect at least a portion of the eleventh light L11 emitted from the light emitting layer EML to the first light-blocking layer BM1. At least a portion of the eleventh light L11 incident on the first light-blocking layer BM1 may be reflected toward the outside of the display device DDe. For example, at least a portion of the eleventh light L1 1 incident on the third surface (for example, the third surface BM1-S3 of FIG. 25) of the first light-blocking layer BM1 may be reflected toward the outside of the display device DDe. For example, the first light-blocking layer BM1 may reflect at least a portion of the eleventh light L11 reflected by the fifth reflecting pattern RF5 to the outside of the display device DDe.

For example, as the display device DDe according to an embodiment may include the first light-blocking layer BM1, the second light-blocking layer BM2, the third reflecting pattern RF3, the fourth reflecting pattern RF4, the fifth reflecting pattern RF5, and the sixth reflecting pattern RF6, at least a portion of light obliquely incident on the first color filter CF1, the second color filter CF2, and the third color filter CF3 may be recycled, and thus, the light efficiency of the display device DDe may be further improved.

FIG. 25 is an enlarged schematic cross-sectional view illustrating an area C of FIG. 23.

Referring further to FIG. 25, the fifth reflecting pattern RF5 may include a first surface RF5-S1, a second surface RF5-S2, a third surface RF5-S3, and a fourth surface RF5-S4. For example, the fifth reflecting pattern RF5 may be a portion surrounded by the first surface RF5-S1, the second surface RF5-S2, the third surface RF5-S3, and the fourth surface RF5-S4 in the cross-sectional view.

The first surface RF5-S1 may form a seventh inclination angle Θ7 with the lower surface PRP-L of the phase delay plate PRP. For example, the first surface RF5-S1 may form a seventh inclination angle Θ7 with a fourth parallel surface VL4 which is a surface parallel to the lower surface PRP-L of the phase delay plate PRP. Although not illustrated in FIG. 25, the third surface RF5-S3 may form the same inclination angle as the seventh inclination angle Θ7 with the lower surface PRP-L of the phase delay plate PRP. In other words, the third surface RF5-S3 may form the same inclination angle as the seventh inclination angle Θ7 with the fourth parallel surface VL4 which is a surface parallel to the lower surface PRP-L of the phase delay plate PRP.

The second surface RF5-S2 may form an eighth inclination angle Θ8 with the lower surface PRP-L of the phase delay plate PRP. For example, the second surface RF5-S2 may form an eighth inclination angle Θ8 with the fourth parallel surface VL4 which is a surface parallel to the lower surface PRP-L of the phase delay plate PRP. Although not illustrated in FIG. 25, the fourth surface RF5-S4 may form the same inclination angle as the eighth inclination angle Θ8 with the lower surface PRP-L of the phase delay plate PRP. In other words, the fourth surface RF5-S4 may form the same inclination angle as the eighth inclination angle Θ8 with the fourth parallel surface VL4 which is a surface parallel to the lower surface PRP-L of the phase delay plate PRP.

In an embodiment, the seventh inclination angle Θ7 may be greater than the first inclination angle θ1. The seventh inclination angle Θ7 may be greater than the second inclination angle Θ2. In an embodiment, the eighth inclination angle Θ8 may be less than the fifth inclination angle θ5 (for example, the fifth inclination angle θ5 of FIG. 20). The eighth inclination angle Θ8 may be less than the sixth inclination angle (for example, the sixth inclination angle Θ6 of FIG. 20). Accordingly, proportion of the light emitted to the outside of the display device DDe may increase by the first light-blocking layer BM1, the third reflecting pattern RF3, and the fifth reflecting pattern RF5 among the light obliquely incident on the second color filter CF2. Accordingly, the light efficiency of the display device DDe may be improved.

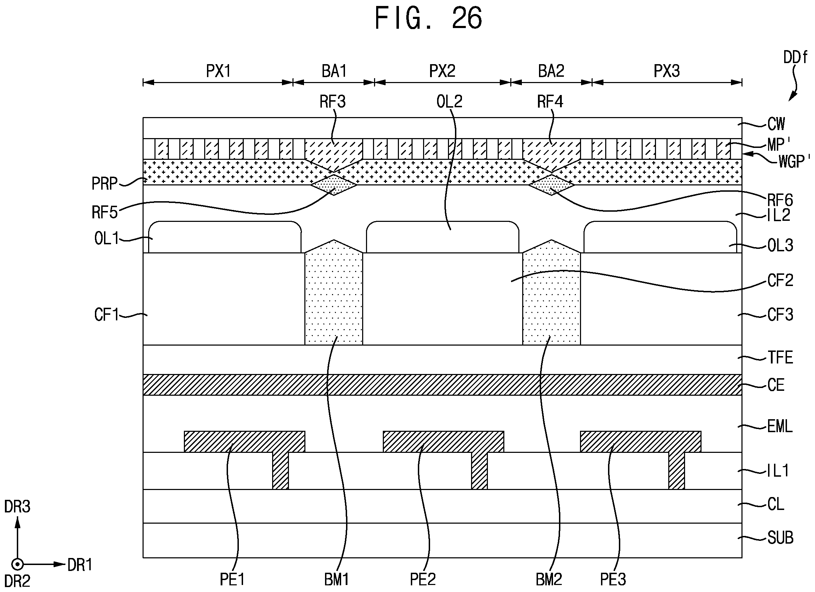

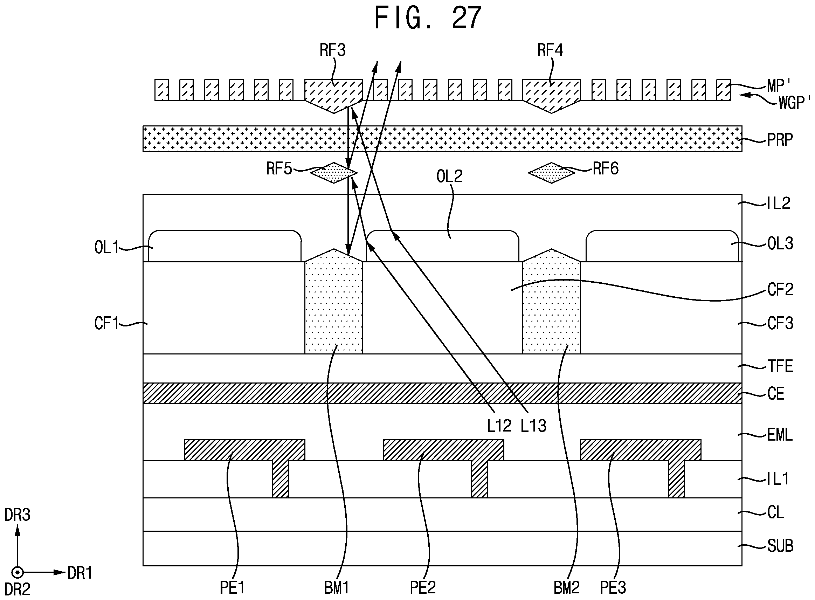

FIG. 26 is a schematic cross-sectional view illustrating a display device according to an embodiment. FIG. 27 is a schematic cross-sectional view for illustrating a process in which light emitted from a light emitting layer included in the display device of FIG. 26 is recycled.

The display device DDf according to an embodiment described with reference to FIG. 26 may be different in the configurations of the first organic layer OL1, the second organic layer OL2, and the third organic layer OL3 compared to the display device DDe described with reference to FIG. 23. Therefore, overlapping description may be omitted.

Referring to FIGS. 26 and 27, the first organic layer OL1 may be disposed on the first color filter CF1. For example, the first organic layer OL1 may cover at least a portion of the first color filter CF1. For example, the first organic layer OL1 may cover the upper surface of the first color filter CF1. For example, the first organic layer OL1 may be disposed in at least a portion of the first pixel area PX1.

The second organic layer OL2 may be disposed on the second color filter CF2. For example, the second organic layer OL2 may cover at least a portion of the second color filter CF2. For example, the second organic layer OL2 may cover an upper surface of the second color filter CF2. For example, the second organic layer OL2 may be disposed in at least a portion of the second pixel area PX2.

The third organic layer OL3 may be disposed on the third color filter CF3. For example, the third organic layer OL3 may cover at least a portion of the third color filter CF3. For example, the third organic layer OL3 may cover an upper surface of the third color filter CF3. For example, the third organic layer OL3 may be disposed in at least a portion of the third pixel area PX3.

In an embodiment, the refractive index of the first organic layer OL1 may be greater than the refractive index of the second insulating layer IL2. The refractive index of the second organic layer OL2 may be greater than the refractive index of the second insulating layer IL2. The refractive index of the third organic layer OL3 may be greater than the refractive index of the second insulating layer IL2.

For example, each of the first organic layer OL1, the second organic layer OL2, and the third organic layer OL3 may include an organic material. For example, each of the first organic layer OL1, the second organic layer OL2, and the third organic layer OL3 may include an organic material such as an epoxy resin, a siloxane resin, a polyimide resin, a photoresist, or the like within the scope of the disclosure. These materials may be used alone or in combination with each other.

As the display device DDf may include the first organic layer OL1, the second organic layer OL2, and the third organic layer OL3, light efficiency of the display device DDf may be further improved. A mechanism for improving the light efficiency of the display device DDf will be described below, focusing on the second pixel area PX2.

The light emitting layer EML may emit twelfth light L12. The twelfth light L12 may be obliquely incident on the second color filter CF2. For example, the twelfth light L12 may be emitted from the light emitting layer EML toward a portion other than the second surface (for example, the second surface RF5-S2 of FIG. 25) of the fifth reflecting pattern RF5. As the refractive index of the second organic layer OL2 is greater than the refractive index of the second insulating layer IL2, the twelfth light L12 may be refracted at the boundary between the second organic layer OL2 and the second insulating layer IL2. For example, the twelfth light L12 may be refracted toward the second surface of the fifth reflecting pattern RF5 at the boundary surface between the second organic layer OL2 and the second insulating layer IL2. Accordingly, the twelfth light L12 may be emitted to the outside of the display device DDf through the fifth reflecting pattern RF5 and the first light-blocking layer BM1. For example, as the display device DDf may include the second organic layer OL2, light emitted from the light emitting layer EML toward a portion other than the second surface of the fifth reflecting pattern RF5 may be refracted toward the fifth reflecting pattern RF5, and may be emitted to the outside of the display device DDf through the fifth reflecting pattern RF5 and the first light-blocking layer BM1. For example, as the display device DDf may include the second organic layer OL2, proportion of recycled light among the light obliquely incident on the second color filter CF2 may increase.

The light emitting layer EML may emit thirteenth light L13. The thirteenth light L13 may be obliquely incident on the second color filter CF2. For example, the thirteenth light L13 may be emitted from the light emitting layer EML toward a portion other than the second surface (for example, the second surface RF3-S2 of FIG. 25) of the third reflecting pattern RF3. As the refractive index of the second organic layer OL2 is greater than the refractive index of the second insulating layer IL2, the thirteenth light L13 may be refracted at the boundary surface between the second organic layer OL2 and the second insulating layer IL2. For example, the thirteenth light L13 may be refracted toward the second surface of the third reflecting pattern RF3 at the boundary surface between the second organic layer OL2 and the second insulating layer IL2. Accordingly, the thirteenth light L13 may be emitted to the outside of the display device DDf through the third reflecting pattern RF3 and the fifth reflecting pattern RF3. For example, as the display device DDf may include the second organic layer OL2, light emitted from the light emitting layer EML toward a portion other than the second surface of the third reflecting pattern RF3 may be refracted toward the third reflecting pattern RF3, and may be emitted to the outside the display device DDf through the third reflecting pattern RF3 and the fifth reflecting pattern RF5. For example, as the display device DDf may include the second organic layer OL2, proportion of recycled light among the light obliquely incident on the second color filter CF2 may increase.

The disclosure can be applied to various display devices. For example, the disclosure is applicable to various display devices such as display devices for vehicles, ships and aircraft, portable communication devices, display devices for exhibition or information transmission, medical display devices, and the like within the scope of the disclosure.

The foregoing is illustrative of embodiments and is not to be construed as limiting thereof. Although embodiments have been described, those skilled in the art will readily appreciate that many modifications are possible in the embodiments without materially departing from the novel teachings and advantages of the disclosure. Accordingly, all such modifications are intended to be included within the scope of the disclosure and as defined in the claims. Therefore, it is to be understood that the foregoing is illustrative of various embodiments and is not to be construed as limited to the embodiments disclosed, and that modifications to the disclosed embodiments, as well as other embodiments, are intended to be included within the scope of the appended claims.

Embodiments are set out in the following clauses:
Clause 1. A display device comprising:
   a substrate including a plurality of pixel areas and a non-light emitting area disposed between adjacent pixel areas of the plurality of pixel areas;
   a driving circuit layer disposed on the substrate;
   a light emitting layer disposed on the driving circuit layer;
   a light-blocking layer disposed in the non-light emitting area on the light emitting layer and, in a cross-sectional view, the light-blocking layer including:
      a first surface facing the substrate;
      a second surface opposite to the first surface and forming a first inclination angle with the first surface; and
      a third surface opposite to the first surface, contacting the second surface, and forming a second inclination angle with the first surface;
   an insulating layer disposed on the light-blocking layer and including a groove in the non-light emitting area; and
   a reflecting pattern filling at least a portion of the groove.
Clause 2. The display device of clause 1, wherein the first inclination angle and the second inclination angle are substantially the same as each other.
Clause 3. The display device of clause 1 or clause 2, wherein the groove has a substantially triangular shape in cross-sectional view.
Clause 4. The display device of any one of clauses 1 to 3, further comprising:
   a phase delay plate disposed on the insulating layer.
Clause 5. The display device of clause 4, wherein the phase delay plate includes an about λ/4 phase delay plate.
Clause 6. The display device of clause 4 or clause 5, further comprising:
   a wire grid polarizing plate disposed on the phase delay plate and including metal patterns spaced apart from each other at a selectable interval.
Clause 7. The display device of any one of clauses 4 to 6, wherein a boundary surface at which the reflecting pattern and the insulating layer contact each other forms a third inclination angle with a lower surface of the phase delay plate, and
   the third inclination angle is greater than each of the first inclination angle and the second inclination angle.
Clause 8. The display device of any one of clauses 1 to 7, wherein the light-blocking layer includes a metal.
Clause 9. The display device of any one of clauses 1 to 8, wherein the reflecting pattern includes at least one of aluminium, gold, silver, copper, chromium, tungsten, iron, and nickel.
Clause 10. The display device of any one of clauses 1 to 9, wherein the second surface is a substantially curved surface.
Clause 11. The display device of any one of clauses 1 to 10, further comprising:
   a color filter disposed in the plurality of pixel areas on the light emitting layer.
Clause 12. The display device of clause 11, further comprising:
   an organic layer covering at least a portion of the color filter.
Clause 13. The display device of clause 12, wherein a refractive index of the organic layer is greater than a refractive index of the insulating layer.
Clause 14. The display device of any one of clauses 1 to 13, wherein the groove is a portion from which at least a portion of the insulating layer is removed from an upper surface of the insulating layer.
Clause 15. The display device of any one of clauses 1 to 14, wherein the light-blocking layer reflects at least a portion of light reflected by the reflecting pattern to an outside of the display device.
Clause 16. A display device comprising:
   a substrate including a plurality of pixel areas and a non-light emitting area disposed between adjacent pixel areas of the plurality of pixel areas;
   a driving circuit layer disposed on the substrate;
   a light emitting layer disposed on the driving circuit layer;
   a light-blocking layer disposed in the non-light emitting area on the light emitting layer and, in a cross-sectional view, the light-blocking layer including:
      a first surface facing the substrate;
      a second surface opposite to the first surface and forming a first inclination angle with the first surface; and
      a third surface opposite to the first surface, contacting the second surface, and forming a second inclination angle with the first surface;
   an insulating layer disposed on the light-blocking layer;
   a phase delay plate disposed on the insulating layer; and
   a wire grid polarizing plate disposed on the phase delay plate, wherein the wire grid polarizing plate includes a reflecting pattern in the non-light emitting area.
Clause 17. The display device of clause 16, in a cross-sectional view, the reflecting pattern includes:
   a fourth surface reflecting light emitted from the light emitting layer to the light-blocking layer;
   a fifth surface contacting the fourth surface; and
   a sixth surface opposite to each of the fourth surface and the fifth surface.
Clause 18. The display device of clause 17, wherein the fourth surface forms a third inclination angle with the sixth surface, and the fifth surface forms a fourth inclination angle with the sixth surface.
Clause 19. The display device of clause 18, wherein the third inclination angle and the fourth inclination angle are substantially the same as each other.
Clause 20. The display device of clause 19, wherein the third inclination angle is greater than each of the first inclination angle and the second inclination angle.
Clause 21. The display device of any one of clauses 17 to 20, wherein the fourth surface is a substantially curved surface.
Clause 22. The display device of any one of clauses 16 to 21, wherein the light-blocking layer includes a metal.
Clause 23. The display device of any one of clauses 16 to 22, further comprising:
   a color filter disposed in the plurality of pixel areas on the light emitting layer.
Clause 24. The display device of clause 23, further comprising:
   an organic layer covering at least a portion of the color filter.
Clause 25. The display device of clause 24, wherein a refractive index of the organic layer is greater than a refractive index of the insulating layer.
Clause 26. The display device of any one of clauses 16 to 25, wherein the light-blocking layer reflects at least a portion of light reflected by the reflecting pattern to an outside of the display device.
Clause 27. A display device comprising:
   a substrate including a plurality of pixel areas and a non-light emitting area disposed between adjacent pixel areas of the plurality of pixel areas;
   a driving circuit layer disposed on the substrate;
   a light emitting layer disposed on the driving circuit layer;
   a light-blocking layer disposed in the non-light emitting area on the light emitting layer and, in a cross-sectional view, the light-blocking layer including:
      a first surface facing the substrate;
      a second surface opposite to the first surface and forming a first inclination angle with the first surface; and
      a third surface opposite to the first surface, contacting the second surface, and forming a second inclination angle with the first surface;
   an insulating layer disposed on the light-blocking layer and including a first groove in the non-light emitting area;
   a phase delay plate disposed on the insulating layer and including a second groove overlapping the first groove in a plan view;
   a first reflecting pattern filling at least a portion of the first groove and at least a portion of the second groove; and
   a wire grid polarizing plate disposed on the phase delay plate, wherein the wire grid polarizing plate includes a second reflecting pattern in the non-light emitting area.
Clause 28. The display device of clause 27, wherein the first reflecting pattern reflects at least a portion of light reflected by the second reflecting pattern to an outside of the display device.
Clause 29. The display device of clause 27 or clause 28, wherein the light-blocking layer reflects at least a portion of light reflected by the first reflecting pattern to an outside of the display device.
Clause 30. The display device of any one of clauses 27 to 29, wherein the light-blocking layer includes a metal.
Clause 31. The display device of any one of clauses 27 to 30, further comprising:
   a color filter disposed in the plurality of pixel areas on the light emitting layer.
Clause 32. The display device of clause 31, further comprising:
   an organic layer covering at least a portion of the color filter.
Clause 33. The display device of clause 32, wherein a refractive index of the organic layer is greater than a refractive index of the insulating layer.

## Claims

1. A display device comprising:
a substrate including a plurality of pixel areas and a non-light emitting area disposed between adjacent pixel areas of the plurality of pixel areas;
a driving circuit layer disposed on the substrate;
a light emitting layer disposed on the driving circuit layer;
a light-blocking layer disposed in the non-light emitting area on the light emitting layer and, in a cross-sectional view, the light-blocking layer including:
a first surface facing the substrate;
a second surface opposite to the first surface and forming a first inclination angle with the first surface; and
a third surface opposite to the first surface, contacting the second surface, and forming a second inclination angle with the first surface;
an insulating layer disposed on the light-blocking layer and including a groove in the non-light emitting area; and
a reflecting pattern filling at least a portion of the groove.

2. The display device of claim 1, wherein the first inclination angle and the second inclination angle are substantially the same as each other.

3. The display device of claim 1 or claim 2, wherein the groove has a substantially triangular shape in cross-sectional view.

4. The display device of any one of claims 1 to 3, further comprising:
a phase delay plate disposed on the insulating layer.

5. The display device of claim 4, wherein:
(i) the phase delay plate includes an about λ/4 phase delay plate; and/or
(ii) the display device further comprises:
a wire grid polarizing plate disposed on the phase delay plate and including metal patterns spaced apart from each other at a selectable interval; and/or
(iii) a boundary surface at which the reflecting pattern and the insulating layer contact each other forms a third inclination angle with a lower surface of the phase delay plate, and
the third inclination angle is greater than each of the first inclination angle and the second inclination angle.

6. The display device of any one of claims 1 to 5, wherein:
(i) the light-blocking layer includes a metal; and/or
(ii) the reflecting pattern includes at least one of aluminium, gold, silver, copper, chromium, tungsten, iron, and nickel; and/or
(iii) the second surface is a substantially curved surface.

7. The display device of any one of claims 1 to 6, further comprising:
a color filter disposed in the plurality of pixel areas on the light emitting layer, optionally further comprising an organic layer covering at least a portion of the color filter, further optionally wherein a refractive index of the organic layer is greater than a refractive index of the insulating layer.

8. The display device of any one of claims 1 to 7, wherein:
(i) the groove is a portion from which at least a portion of the insulating layer is removed from an upper surface of the insulating layer; and/or
(ii) the light-blocking layer is configured to reflect at least a portion of light reflected by the reflecting pattern to an outside of the display device.

9. A display device comprising:
a substrate including a plurality of pixel areas and a non-light emitting area disposed between adjacent pixel areas of the plurality of pixel areas;
a driving circuit layer disposed on the substrate;
a light emitting layer disposed on the driving circuit layer;
a light-blocking layer disposed in the non-light emitting area on the light emitting layer and, in a cross-sectional view, the light-blocking layer including:
a first surface facing the substrate;
a second surface opposite to the first surface and forming a first inclination angle with the first surface; and
a third surface opposite to the first surface, contacting the second surface, and forming a second inclination angle with the first surface;
an insulating layer disposed on the light-blocking layer;
a phase delay plate disposed on the insulating layer; and
a wire grid polarizing plate disposed on the phase delay plate, wherein the wire grid polarizing plate includes a reflecting pattern in the non-light emitting area.

10. The display device of claim 9, in a cross-sectional view, the reflecting pattern includes:
a fourth surface configured to reflect light emitted from the light emitting layer to the light-blocking layer;
a fifth surface contacting the fourth surface; and
a sixth surface opposite to each of the fourth surface and the fifth surface, optionally wherein the fourth surface forms a third inclination angle with the sixth surface, and the fifth surface forms a fourth inclination angle with the sixth surface, further optionally wherein the third inclination angle and the fourth inclination angle are substantially the same as each other, further optionally wherein the third inclination angle is greater than each of the first inclination angle and the second inclination angle.

11. The display device of claim 10, wherein the fourth surface is a substantially curved surface.

12. The display device of any one of claims 9 to 11, wherein:
(i) the light-blocking layer includes a metal; and/or
(ii) the display device further comprises:
a color filter disposed in the plurality of pixel areas on the light emitting layer, optionally further comprising an organic layer covering at least a portion of the color filter, further optionally wherein a refractive index of the organic layer is greater than a refractive index of the insulating layer.

13. The display device of any one of claims 9 to 12, wherein the light-blocking layer is configured to reflect at least a portion of light reflected by the reflecting pattern to an outside of the display device.

14. A display device comprising:
a substrate including a plurality of pixel areas and a non-light emitting area disposed between adjacent pixel areas of the plurality of pixel areas;
a driving circuit layer disposed on the substrate;
a light emitting layer disposed on the driving circuit layer;
a light-blocking layer disposed in the non-light emitting area on the light emitting layer and, in a cross-sectional view, the light-blocking layer including:
a first surface facing the substrate;
a second surface opposite to the first surface and forming a first inclination angle with the first surface; and
a third surface opposite to the first surface, contacting the second surface, and forming a second inclination angle with the first surface;
an insulating layer disposed on the light-blocking layer and including a first groove in the non-light emitting area;
a phase delay plate disposed on the insulating layer and including a second groove overlapping the first groove in a plan view;
a first reflecting pattern filling at least a portion of the first groove and at least a portion of the second groove; and
a wire grid polarizing plate disposed on the phase delay plate, wherein the wire grid polarizing plate includes a second reflecting pattern in the non-light emitting area.

15. The display device of claim 14, wherein:
(i) the first reflecting pattern is configured to reflect at least a portion of light reflected by the second reflecting pattern to an outside of the display device; and/or
(ii) the light-blocking layer is configured to reflect at least a portion of light reflected by the first reflecting pattern to an outside of the display device; and/or
(iii) the light-blocking layer includes a metal; and/or
(iv) the display device further comprises:
a color filter disposed in the plurality of pixel areas on the light emitting layer, optionally further comprising an organic layer covering at least a portion of the color filter, further optionally wherein a refractive index of the organic layer is greater than a refractive index of the insulating layer.
